(19) Europäisches Patentamt
European Patent Office
Office européen des brevets

(11) EP 3 762 977 B1

(12) **EUROPEAN PATENT SPECIFICATION**

(45) Date of publication and mention of the grant of the patent:
**18.10.2023 Bulletin 2023/42**

(21) Application number: **19731780.3**

(22) Date of filing: **04.04.2019**

(51) International Patent Classification (IPC):
***C09K 11/06*** (2006.01) ***C09K 11/70*** (2006.01)
***C09K 11/62*** (2006.01) ***C09K 11/67*** (2006.01)
***H10K 50/115*** (2023.01) ***H10K 101/20*** (2023.01)
***H10K 101/10*** (2023.01) ***H01L 33/50*** (2010.01)

(52) Cooperative Patent Classification (CPC):
**C09K 11/06; C09K 11/62; C09K 11/672; C09K 11/673; C09K 11/70; H01L 33/502; H10K 50/115;** C09K 2211/1007; C09K 2211/1029; H10K 50/11; H10K 2101/10; H10K 2101/20

(86) International application number:
**PCT/IB2019/000393**

(87) International publication number:
**WO 2019/197902 (17.10.2019 Gazette 2019/42)**

(54) **ELECTROLUMINESCENT DISPLAY DEVICES AND METHODS OF MAKING THE SAME**

ELEKTROLUMINESZENTE ANZEIGEVORRICHTUNGEN UND VERFAHREN ZUR HERSTELLUNG DAVON

DISPOSITIFS D'AFFICHAGE ÉLECTROLUMINESCENTS ET LEURS PROCÉDÉS DE FABRICATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **11.04.2018 US 201862656074 P**
**18.05.2018 US 201862673344 P**
**25.07.2018 US 201862703226 P**

(43) Date of publication of application:
**13.01.2021 Bulletin 2021/02**

(73) Proprietor: **Kyulux, Inc.**
**Nishi-ku, Fukuoka 819-0388 (JP)**

(72) Inventors:
- **STUBBS, Stuart**
**Manchester GB M13 9NT (GB)**
- **GRESTY, Nathalie**
**Manchester GB M13 9NT (GB)**
- **HARRIS, James**
**Manchester GB M13 9NT (GB)**
- **PICKETT, Nigel**
**Manchester GB M13 9NT (GB)**
- **LIU, Zugang**
**Manchester GB M13 9NT (GB)**
- **ENDO, Ayataka**
**Fukuoka, 819--0388 (JP)**
- **BROWN, Chris**
**Fukuoka, 819--0388 (JP)**

(74) Representative: **Marks & Clerk LLP**
**15 Fetter Lane**
**London EC4A 1BW (GB)**

(56) References cited:
**WO-A1-2015/135625** **CN-A- 106 997 889**
**CN-A- 106 997 890** **CN-A- 106 997 926**
**US-A1- 2016 268 516** **US-A1- 2018 053 907**

- **RYOICHI ISHIMATSU ET AL: "Solvent Effect on Thermally Activated Delayed Fluorescence by 1,2,3,5-Tetrakis(carbazol-9-yl)-4,6-dicyan obenzene", THE JOURNAL OF PHYSICAL CHEMISTRY A, vol. 117, no. 27, 12 June 2013 (2013-06-12), pages 5607-5612, XP055122928, ISSN: 1089-5639, DOI: 10.1021/jp404120s**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 762 977 B1

## Description

FIELD OF THE INVENTION

The presently claimed invention relates to an emissive layer for an electroluminescent display devices. More particularly, the presently claimed invention relates to electroluminescent display devices which utilize a two-dopant system for fluorescence. More particularly, the presently claimed invention relates to electroluminescent display devices which utilize a two-dopant system for fluorescence wherein the two dopants are quantum dots and molecules which exhibit thermally activated delayed fluorescence.

BACKGROUND OF THE DISCLOSURE

*Semiconductor nanomaterials*

There has been substantial interest in the preparation and characterization of compound semiconductors consisting of particles with dimensions in the order of 2-100 nm, often referred to as quantum dots (QDs) and/or nanoparticles. Studies in this field have focused mainly on the size-tunable electronic, optical and chemical properties of nanoparticles. Semiconductor nanoparticles are gaining interest due to their potential in commercial applications as diverse as biological labeling, solar cells, catalysis, biological imaging, and light-emitting diodes.

Two fundamental factors (both related to the size of the individual semiconductor nanoparticles) are primarily responsible for their unique properties. The first is the large surface-to-volume ratio: as a particle becomes smaller, the ratio of the number of surface atoms to those in the interior increases. This leads to the surface properties playing an important role in the overall properties of the material. The second factor is that, for many materials (including semiconductor nanoparticles), the electronic properties of the material change with particle size. Moreover, because of quantum confinement effects, the band gap typically becomes gradually larger as the size of the nanoparticle decreases. This effect is a consequence of the confinement of an "electron in a box," giving rise to discrete energy levels similar to those observed in atoms and molecules, rather than a continuous band as observed in the corresponding bulk semiconductor material. Semiconductor nanoparticles tend to exhibit a narrow bandwidth emission that is dependent upon the particle size and composition of the nanoparticle material. The first excitonic transition (band gap) increases in energy with decreasing particle diameter.

Semiconductor nanoparticles of a single semiconductor material, referred to herein as "core nanoparticles," along with an outer organic passivating layer, tend to have relatively low quantum efficiencies due to electron-hole recombination occurring at defects and dangling bonds situated on the nanoparticle surface that can lead to non-radiative electron-hole recombinations.

One method to eliminate defects and dangling bonds on the inorganic surface of the nanoparticle is to grow a second inorganic material (typically having a wider band-gap and small lattice mismatch to that of the core material) on the surface of the core particle to produce a "core-shell" particle. Core-shell particles separate carriers confined in the core from surface states that would otherwise act as non-radiative, recombination centers. One example is ZnS grown on the surface of CdSe cores. Another approach is to prepare a core-multi shell structure where the "electron-hole" pair is completely confined to a single shell layer consisting of a few monolayers of a specific material such as a quantum dot-quantum well structure. Here, the core is typically a wide bandgap material, followed by a thin shell of narrower bandgap material, and capped with a further wide-bandgap layer. An example is CdS/HgS/CdS grown using substitution of Hg for Cd on the surface of the core nanocrystal to deposit just a few monolayers of HgS that is then overgrown by monolayers of CdS. The resulting structures exhibit clear confinement of photo-excited carriers in the HgS layer.

The most-studied and prepared semiconductor nanoparticles to date have been so-called "II-VI materials," for example, ZnS, ZnSe, CdS, CdSe, and CdTe, as well as core-shell and core-multi shell structures incorporating these materials. However, cadmium and other restricted heavy metals used in conventional QDs are highly toxic elements and are of major concern in commercial applications.

Other semiconductor nanoparticles that have generated considerable interest include nanoparticles incorporating Group III-V and Group IV-VI materials, such as GaN, GaP, GaAs, InP, and InAs. Due to their increased covalent nature, III-V and IV-VI highly crystalline semiconductor nanoparticles are more difficult to prepare and much longer annealing times are usually required. However, there are now reports of III-VI and IV-VI materials being prepared in a similar manner to that used for the II-VI materials.

*Organic Light-Emitting Diodes (OLEDs)*

In recent years, electroluminescent display devices, specifically organic light-emitting diodes (OLEDs), have been of great interest within the display industry. An OLED is a light-emitting diode (LED) in which a film of organic

compounds is placed between two conductors, which film emits light in response to excitation, such as an electric current. OLEDs are useful in displays, such as television screens, computer monitors, mobile phones, and tablets. A problem inherent in OLED displays is the limited lifetime of the organic compounds. OLEDs which emit blue light, in particular, degrade at a significantly increased rate as compared to green or red OLEDs.

OLED materials rely on the radiative decay of molecular excited states (excitons) generated by recombination of electrons and holes in a host transport material. Two types of excited states are created when charge recombines in an OLED - bright singlet excitons (with a total spin of 0) and dark triplet excitons (with a total spin of 1) - but only the singlets directly give light which fundamentally limits external OLED efficiencies. Spin statistics states that one singlet exciton is generated for every three triplet excitons after the recombination of holes and electrons in organic semiconductor materials. The efficiency of OLEDs can therefore be substantially increased if the non-emissive triplets can be utilized.

To date, OLED material design has focused on harvesting the remaining energy from the normally dark triplets. Recent work to create efficient phosphors, which emit light from the normally dark triplet state, have resulted in green and red OLEDs. Other colors, such as blue, however, require higher energy excited states which accelerate the degradation process of the OLED.

The fundamental limiting factor to the triplet-singlet transition rate is a value of the parameter $|H_{fi}/\Delta|^2$, where $H_{fi}$ is the coupling energy due to hyperfine or spin-orbit interactions, and $\Delta$ is the energetic splitting between singlet and triplet states. Traditional phosphorescent OLEDs rely on the mixing of singlet and triplet states due to spin-orbital (SO) interaction, increasing $H_{fi}$, and affording a lowest emissive state shared between a heavy metal atom and an organic ligand. This results in energy harvesting from all higher singlet and triplet states, followed by phosphorescence (relatively short-lived emission from the excited triplet). The shortened triplet lifetime reduces triplet exciton annihilation by charges and other excitons. Recent work by others suggests that the limit to the performance of phosphorescent materials has been reached.

It is thought that the solution processability of OLED devices may lead to a low production cost once mass production has been fully established, and can enable the fabrication of devices on flexible substrates, leading to new technologies such as roll-up displays. In an OLED device, the pixels emit directly, enabling a greater contrast ratio and wider viewing angle compared to liquid crystal displays (LCDs). Further, in contrast to LCDs, OLED displays do not require a backlight, allowing a true black when the OLED is switched off. OLEDs also offer faster response times than LCDs. However, OLED devices typically suffer from poor stability and lifetimes, owing to the lifespans of the organic emissive materials. Blue OLEDs currently display much lower external quantum efficiencies than green and red OLEDs. Further, OLEDs often suffer from broad emission; for display applications narrower emission is desirable to provide better colour purity. Thus, there is a need for a solution-processable emissive device with good stability and lifetime and improved blue emission.

*Molecules Exhibiting Thermally Activated Delayed Fluorescence (TADF)*

It has been discovered that thermally activated delayed fluorescence (TADF), which relies on minimization of $\Delta$ as opposed to maximization of $H_{fi}$, can transfer population between singlet levels and triplet sublevels in a relevant timescale, such as, for example, 1-100 $\mu$s. OLEDs incorporating TADF molecules can reach higher excitation states without rapid degradation. The devices described herein are capable of luminescing at higher energy excitation states than devices previously described.

OLEDs are typically composed of a layer of organic materials or compounds between two electrodes, an anode and a cathode. The organic molecules are electrically conductive as a result of delocalization of $\pi$ electronics caused by conjugation over part or all of the molecule. When a voltage is applied, electrons from the highest occupied molecular orbital (HOMO) present at the anode flow into the lowest unoccupied molecular orbital (LUMO) of the organic molecules present at the cathode. Removal of electrons from the HOMO is also referred to as inserting electron holes into the HOMO. Electrostatic forces bring the electrons and the holes towards each other until they recombine and form an exciton (which is the bound state of the electron and the hole). As the excited state decays and the energy levels of the electrons relax, radiation having a frequency in the visible spectrum is emitted. The frequency of this radiation depends on the band gap of the material, which is the difference in energy between the HOMO and the LUMO.

Because electrons and holes are fermions with half integer spin, an exciton may either be in a singlet state or a triplet state depending on how the spins of the electron and hole have been combined. Statistically, three triplet excitons will be formed for each singlet exciton. Decay from triplet states is spin forbidden, which results in increases in the timescale of the transition and limits the internal efficiency of fluorescent devices.

Thermally activated delayed fluorescence (TADF) seeks to minimize energetic splitting between singlet and triplet states ($\Delta$). The reduction in exchange splitting from typical values of 0.4-0.7 eV to a gap of the order of the thermal energy (proportional to $k_BT$, where $k_B$ is the Boltzmann constant, and T is temperature) means that thermal agitation can transfer population between singlet levels and triplet sublevels in a relevant timescale even if the coupling between states is small.

TADF molecules consist of donor and acceptor moieties connected directly by a covalent bond or via a conjugated linker (or "bridge"). A "donor" moiety is likely to transfer electrons from its HOMO upon excitation to the "acceptor" moiety. An "acceptor" moiety is likely to accept the electrons from the "donor" moiety into its LUMO. The donor-acceptor nature of TADF molecules results in low-lying excited states with charge-transfer character that exhibit very low Δ. Since thermal molecular motions can randomly vary the optical properties of donor-acceptor systems, a rigid three-dimensional arrangement of donor and acceptor moieties can be used to limit the non-radiative decay of the charge-transfer state by internal conversion during the lifetime of the excitation.

It is beneficial, therefore, to decrease energetic splitting between singlet and triplet states (Δ), and to create a system with increased reversed intersystem crossing (RISC) capable of exploiting triplet excitons. Such a system may result in decreased emission lifetimes. Systems with these features may be capable of emitting blue light without being subject to the rapid degradation prevalent in blue OLEDs of the prior art. CN106997926 describes a white light quantum dot electroluminescent device, which comprises a light emitting layer comprising a quantum dot material and a thermally-activated delayed fluorescence (TADF) material. CN106997890 describes a color display device based on quantum dot electroluminescent devices, which comprises multiple quantum dot electroluminescent devices arranged in an array and a color filter. WO 2015/135625 describes a formulation containing organic materials for producing organic electronic devices that have a low failure rate. CN106997889 describes an RGB color display device based on quantum dot electroluminescent devices. US 2018/053907 describes a quantum dot light-emitting device, a fabricating method thereof, a display substrate and a display apparatus.

BRIEF DESCRIPTION OF THE DRAWINGS

FIG. 1 is a schematic illustration of an exemplary electroluminescent quantum dotcontaining light-emitting diode (QD-LED) device structure in accordance with various aspects of the present disclosure;
FIG. 2 depicts an energy level diagram of a TADF molecule;
FIG. 3 depicts an energy level diagram of a two-dopant system in accordance with various aspects of the present disclosure;
FIG. 4 is a schematic illustration of alternative bases for critical distance ($r_o$) determination in accordance with various aspects of the present disclosure;
FIG. 5 is a graph illustrating the spectral overlap of the emission spectrum of an exemplary TADF molecule and the absorption spectrum of an exemplary QD in accordance with various aspects of the present disclosure;
FIG. 6 is a graph illustrating the integrated spectral overlap of the emission spectrum of the exemplary TADF molecule and the absorption spectrum of the exemplary QD of FIG. 5 in accordance with various aspects of the present disclosure;
FIG. 7 is an energy level diagram of an exemplary electroluminescent QD-LED device constructed in accordance with various aspects of the present disclosure;
FIG. 8 is a graph showing maximum luminance ($cd/m^2$) values exhibited by variations of the QD-LED device of FIG. 7 constructed in accordance with various aspects of the present disclosure;
FIG. 9 is a graph showing external quantum efficiencies (EQEs) exhibited by variations of the QD-LED device of FIG. 7 constructed in accordance with various aspects of the present disclosure;
FIG. 10 is a graph showing emission spectra of the QD-LED device of FIG. 7 and variations thereof constructed in accordance with various aspects of the present disclosure;
FIG. 11 is an energy level diagram of another exemplary electroluminescent QD-LED device constructed in accordance with various aspects of the present disclosure;
FIG. 12 is a graph showing maximum luminance ($cd/m^2$) values exhibited by variations of the QD-LED device of FIG. 11 constructed in accordance with various aspects of the present disclosure;
FIG. 13 is a graph showing external quantum efficiencies (EQEs) exhibited by variations of the QD-LED device of FIG. 11 constructed in accordance with various aspects of the present disclosure;
FIG. 14 is a graph showing emission spectra of the QD-LED device of FIG. 11 and variations thereof constructed in accordance with various aspects of the present disclosure;
FIG. 15 is a graph showing the photoluminescence spectrum of an emissive film comprising TADF molecules and QDs constructed in accordance with various aspects of the present disclosure;
FIG. 16 is a graph showing the photoluminescence intensity versus time of the emissive film comprising of FIG. 15;
FIG. 17 is an energy level diagram of yet another exemplary electroluminescent QD-LED device constructed in accordance with various aspects of the present disclosure;
FIG. 18 is a graph showing external quantum efficiencies (EQEs) exhibited by variations of the QD-LED device of FIG. 17 constructed in accordance with various aspects of the present disclosure;

FIG. 19 is another graph showing external quantum efficiencies (EQEs) exhibited by variations of the QD-LED device of FIG. 17 constructed in accordance with various aspects of the present disclosure; and

FIG. 20 is a graph showing emission spectra of the QD-LED device of FIG. 17 as produced in Example 15 in accordance with various aspects of the present disclosure.

DETAILED DESCRIPTION

The following description of the embodiments is merely exemplary in nature and is in no way intended to limit the subject matter of the present disclosure, their application, or uses.

As used throughout, ranges are used as shorthand for describing each and every value that is within the range. Any value within the range can be selected as the terminus of the range. Unless otherwise specified, all percentages and amounts expressed herein and elsewhere in the specification should be understood to refer to percentages by weight.

For the purposes of this specification and appended claims, unless otherwise indicated, all numbers expressing quantities, percentages or proportions, and other numerical values used in the specification and claims, are to be understood as being modified in all instances by the term "about." The use of the term "about" applies to all numeric values, whether or not explicitly indicated. This term is construed as including a deviation of $\pm 10$ percent, alternatively $\pm 5$ percent, and alternatively $\pm 1$ percent of the given numeric value provided such a deviation does not alter the end function or result of the value. Accordingly, unless indicated to the contrary, the numerical parameters set forth in this specification and attached claims are approximations that can vary depending upon the desired properties sought to be obtained by the present invention.

It is noted that, as used in this specification and the appended claims, the singular forms "a," "an," and "the," include plural references unless expressly and unequivocally limited to one referent. As used herein, the term "include" and its grammatical variants are intended to be non-limiting, such that recitation of items in a list is not to the exclusion of other like items that can be substituted or added to the listed items. For example, as used in this specification and the following claims, the terms "comprise" (as well as forms, derivatives, or variations thereof, such as "comprising" and "comprises"), "include" (as well as forms, derivatives, or variations thereof, such as "including" and "includes") and "has" (as well as forms, derivatives, or variations thereof, such as "having" and "have") are inclusive (i.e., openended) and do not exclude additional elements or steps. Accordingly, these terms are intended to not only cover the recited element(s) or step(s), but may also include other elements or steps not expressly recited. Furthermore, as used herein, the use of the terms "a" or "an" when used in conjunction with an element may mean "one," but it is also consistent with the meaning of "one or more," "at least one," and "one or more than one." Therefore, an element preceded by "a" or "an" does not, without more constraints, preclude the existence of additional identical elements.

FIG. 1 is a schematic illustration of an exemplary electroluminescent quantum dotcontaining light-emitting diode (QD-LED) device structure. The QD-LED 100 includes a substrate 1, an anode 10, a hole injection layer (HIL) 20, a hole transport layer (HTL) 30, an electron blocking layer (EBL) 40, an emissive layer 50, a hole blocking layer (HBL) 60, an electron transport layer (ETL) 70, and electron injection layer (EIL) 80 and a cathode 90. The QD-LED device structure of FIG. 1 can contain additional layers or omit one or more of the shown layers. Traditional OLED devices may comprise the same device structure, wherein the emissive layer 50 comprises a fluorescent organic material dispersed in a host matrix. One specific type of fluorescent material is an organic molecule which exhibits thermally activated delayed fluorescence (TADF).

Described herein, but not presently claimed, is an emitting layer 50 of the QD-LED 100 that includes a population of quantum dots and a population of TADF molecules dispersed in a host matrix. In accordance with the presently claimed invention, the emitting layer 50 of the QD-LED 100 can include a population of quantum dots and a population of TADF molecules without the use of a host matrix. Also described herein, but not presently claimed, is the emitting layer 50 of the QD-LED 100 can include a population of quantum dots dispersed in a host matrix, while an adjacent layer can include a population of TADF molecules dispersed in a different host matrix. Also described herein, but not presently claimed, is the emitting layer 50 of the QD-LED 100 can include a population of quantum dots, while an adjacent layer can include a population of TADF molecules, with neither layer utilizing a host matrix.

In some instances, the ETL 70 and the EII, 80 are made of different materials. In some instances, a single composition can serve as both the ETL 70 and the EII, 80. In some instances, the ETL 70 and the EII, 80 are made of ZnO nanoparticles. In some instances, the ETL 70 and the EII, 80 are made of doped ZnO nanoparticles having the general formula $Zn_{1-x}M_xO$, where M = Al, Li, Mg, Ca, Y, Cs, or Ga. In some instances, x ranges between about 0.01 and about 0.5, alternatively between 0.025 and about 0.4, alternatively between about 0.05 and 0.3, alternatively between about 0.075 and 0.2, and alternatively between about 0.075 and about 0.15.

FIG. 2 depicts an energy level diagram of a TADF molecule. In a TADF molecule, upon excitation, triplet state excitons are generated as previously discussed. Generally, triplet excitons generated from emitters such as platinum and iridium complexes non-radiatively decay from the triplet state to the ground state and do not contribute to light emission. In TADF molecules, on the other hand, the triplet excitons are upconverted to singlet state excitons via reverse

intersystem crossing (RISC) due to the small energy gap ($\Delta E_{ST}$) between the singlet and triplet states, and light emission can be extracted as delayed fluorescence from the singlet state. In TADF molecules, $\Delta E_{ST}$ is provided by the absorption of thermal energy.

In accordance with various aspects of the present disclosure, a two-dopant system comprising a quantum dot fluorescent emitter dopant a TADF-assistant dopant is provided for use in electroluminescent display devices such as QD-LED devices. QDs may provide advantages over organic fluorophores as fluorescent emitters for TADF-assisted light-emitting devices. Embodiments of the present disclosure are designed to combine the exciton harvesting capabilities of TADF molecules to achieve near unity internal quantum efficiency, with energy transfer of harvested excitons to QDs with high photoluminescence quantum yield, to achieve hyperfluorescent, narrow emission quantum dot devices. The narrow, pseudo-Gaussian emission of QDs may lead to better colour purity and efficiency as compared to organic fluorophores. QD fluorescence emission is tuneable by tuning the particle size and composition, whereas organic fluorophores generally exhibit broad and specific emission profiles. Additionally, the fluorescence quantum yields (QYs) of QDs are typically higher than those of organic fluorophores.

Described herein, but not presently claimed, is an emitting layer of a QD-LED device that can include a population of quantum dots and a population of TADF molecules dispersed in a host matrix. In accordance with the presently claimed invention an emitting layer of a QD-LED device includes a population of quantum dots and a population of TADF molecules and is free of a host matrix. In either instance, emitting layers having both a population of quantum dots and a population of TADF molecules can have a thickness ranging from about 5 nm to about 100 nm, alternatively about 7.5 nm to about 80 nm, alternatively about 10 nm to about 60 nm, alternatively about 12.5 nm to about 40 nm, alternatively about 15 nm to about 20 nm, alternatively about 17.5 nm to about 25 nm, and alternatively about 20 nm. In accordance with the presently claimed invention, the emissive layer has a QD:TADF ratio of about 6:1 to about 1:1 by weight; optionally about 5:1 to about 2:1 by weight; optionally still about 4.5:1 to about 3.5:1 by weight, and further optionally about 4:1 by weight.

Described herein, but not presently claimed, is the emitting layer of a QD-LED that can include a population of quantum dots dispersed in a host matrix, while an adjacent layer can include a population of TADF molecules dispersed in a different host matrix. Also described herein, but not presently claimed, is the emitting layer of a QD-LED that can include a population of quantum dots free of a host matrix, while an adjacent layer can include a population of TADF molecules dispersed in a host matrix. The emitting layer, having QDs with or without a host matrix, can have a thickness ranging from about 2.5 nm to about 100 nm, alternatively about 5 nm to about 80 nm, alternatively about 7.5 nm to about 60 nm, alternatively about 10 nm to about 40 nm, alternatively about 10 nm to about 20 nm, alternatively about 12.5 nm to about 17.5 nm, and alternatively about 15 nm. The adjacent layer, having TADF molecules dispersed in a host matrix, can have a thickness ranging from about 1 nm to about 120 nm, alternatively about 1.5 nm to about 100 nm, alternatively about 2 nm to about 80 nm, alternatively about 2.5 nm to about 60 nm, alternatively about 3 nm to about 40 nm, alternatively about 3.5 nm to about 20 nm, alternatively from about 4 nm to about 10 nm, and alternatively from about 4 nm to about 8 nm. As described herein, but not presently claimed, the TADF molecules-containing adjacent layer can be a hole transport layer (HTL). As described herein, but not presently claimed, the TADF molecules-containing adjacent layer can be a layer serving as both of an electron blocking layer (EBL) and an HTL.

As described herein, but not presently claimed, TADF molecules can be dispersed throughout the entirety of the adjacent layer. As described herein, but not presently claimed, TADF molecules can be dispersed throughout only a portion of the adjacent layer. As described herein, but not presently claimed, TADF molecules can be dispersed throughout only a portion of the adjacent layer, wherein the portion having TADF molecules is situated next to the emissive layer and the portion not having TADF molecules is situated away from the emissive layer. For example, an adjacent layer having a thickness of 40 nm, where the contact point of the emissive layer and the adjacent layer corresponds to an adjacent layer thickness of 0 nm and the portion of the adjacent layer further from the emissive layer corresponds to an adjacent layer thickness of 40 nm, can have TADF molecules dispersed throughout the 0-30 nm portion of the adjacent layer, alternatively TADF molecules dispersed throughout the 0-20 nm portion of the adjacent layer, alternatively TADF molecules dispersed throughout the 0-10 nm portion of the adjacent layer, alternatively TADF molecules dispersed throughout the 0-9 nm portion of the adjacent layer, alternatively TADF molecules dispersed throughout the 0-7 nm portion of the adjacent layer, alternatively TADF molecules dispersed throughout the 0-5 nm portion of the adjacent layer, alternatively TADF molecules dispersed throughout the 0-3 nm portion of the adjacent layer, and alternatively TADF molecules dispersed throughout the 0-2 nm portion of the adjacent layer.

The concentration (in wt% of the layer) of the TADF-molecules within the adjacent layer, when the TADF molecules are dispersed throughout the entire adjacent layer, can range from about 1 wt% to about 50 wt%, alternatively about from about 5 wt% to about 40 wt%, from about 10 wt% to about 30 wt%, alternatively from about 15 wt% to about 25 wt%, and alternatively about 20 wt%. When the TADF molecules are dispersed throughout only a portion adjacent layer, the concentration of the TADF-molecules within that portion can range from about 1 wt% to about 50 wt%, alternatively about from about 5 wt% to about 40 wt%, from about 10 wt% to about 30 wt%, alternatively from about 15 wt% to about 25 wt%, and alternatively about 20 wt%.

FIG. 3 depicts an energy level diagram of a two-dopant system according to various aspects of the present disclosure. When an emissive layer includes only TADF compounds the triplet excitons are upconverted to singlet state excitons via reverse intersystem crossing (RISC) due to the small energy gap ($\Delta E_{ST}$) between the singlet and triplet states, and light emission can be extracted as delayed fluorescence from the singlet state as described above. When TADF molecules are in the presence of QDs, however, the singlet excitons of the TADF molecules are resonantly transferred to a singlet state of the QDs via Förster resonance energy transfer (FRET). Light is then emitted as delayed fluorescence from the singlet state of the QDs. This is true in instances where the TADF molecules and the QDs are in the same emissive layer in accordance with the presently claimed invention; and in instances where the QDs are in an emissive layer and the TADF molecules are in a layer adjacent to the emissive layer which are described herein but not presently claimed.

In some instances, the QDs can be blue-emitting QDs. In other instances, the QDs can be green-emitting QDs. In yet other instances, the QDs can be red-emitting QDs. In yet other instances, the QDs can be any combination of blue-, green- and red-emitting QDs. In yet other instances, the QDs can be UV-emitting QDs. In yet other instances, the QDs can be IR-emitting QDs. In yet other instances, the QDs can be tuned to emit at any wavelength ranging from the UV to the IR regions of the electromagnetic spectrum, depending on the application. To optimize the performance of two-dopant systems in electroluminescent devices, such as OLED devices, it may be advantageous to design QDs having various qualities. First, the QDs should have high oscillator strength. Second, the QDs should be fabricated to have high FRET with the TADF molecule. Third, the QDs should be fabricated to be strong absorbers. Finally, the QDs should be fabricated to exhibit a short excited state lifetime. One of ordinary skill in the art that the above are not necessarily the only qualities that may be optimized in systems according to the present disclosure.

*Maximization of FRET*

In accordance with various aspects of the present disclosure, singlet excitons of the TADF molecule are resonantly transferred to a singlet state of the QDs via FRET. A critical distance for the near-field dipole-dipole coupling mechanism, FRET, can be calculated from the spectral overlap of a TADF molecule (a "fluorescence donor") and a QD (an "absorbance acceptor") according to the well-known Förster mechanism [Förster, Th., Ann. Phys. 437, 55 (1948)]. To maximize the efficiency of FRET between the TADF molecule and the QD, the critical distance should be determined. The critical distance, $r_0$, between the TADF molecule and the QD is the distance at which the FRET efficiency is 50 %, and is defined **Equation 1**:

$$r_0{}^2 = \frac{9}{8\pi}\frac{c^4}{n^4}\kappa^2\eta_D\int\frac{S_D(\omega)\sigma_A(\omega)}{\omega^4}d\omega$$

where c is the speed of light in a vacuum, n is the refractive index of the material, $\kappa^2$ is an orientation factor, $\eta_D$ is the photoluminescence (PL) quantum efficiency of the TADF molecule, $S_D$ is the normalised PL spectrum of the TADF molecule, and $\sigma_A$ is the QD absorption cross-section. [Y.Q. Zhang and X.A. Cao, Appl. Phys. Lett., 2010, 97, 253115]. The critical distance, $r_0$, can thus be manipulated by, for example, altering the PL properties of the TADF molecule (photoluminescence maximum ($PL_{max}$)), full-width at half-maximum (FWHM) and PL quantum efficiency, and $\sigma_A$, which may be influenced by factors such as the shape, composition and architecture of the QDs. The better the spectral overlap between the TADF emission and the QD absorption, the better the transfer efficiency and thus the longer the distance over which the energy can be carried.

FIG. 4 is a schematic illustration of alternative bases for $r_o$ determination. In some instances, $r_0$ can be measured from the centre of the TADF molecule to the centre of the QD core (from which emission takes place in a Type I QD). In other instances, $r_0$ can be measured from the edge of the TADF molecule to the edge of the QD core.

While the TADF molecule is shown in FIG. 4 as a circle or sphere, one of ordinary skill in the art can readily appreciate that the shape of any particular TADF molecule is dependent upon its chemical structure. Additionally, while the QD is shown as being spherical, one of ordinary skill in the art can readily appreciate that the shape of the QDs used in accordance with various aspects of the present disclosure can vary as described herein. QDs used in accordance with various aspects of the present disclosure can be any one of core, core-shell, core-multi shell or quantum dot-quantum well (QD-QW) QDs. If $r_0$ is measured from the edge of the TADF molecule to the edge of the QD core, a QD-QW architecture may be desirable. A QD-QW comprises a narrower band gap first shell sandwiched between a core and a second shell of a wider band gap material, with emission coming from the first shell. Therefore, the distance between the edge of the TADF molecule and edge of the core in a core/shell QD may be greater than that between the edge of the TADF molecule and the edge of the first shell in a QD-QW.

In accordance with the presently claimed invention, TADF molecules may be selected from

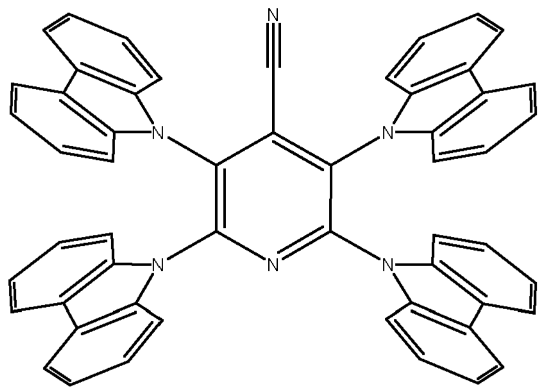

(2,3,5,6-tetra(9H-carbazol-9-yl)isonicotinonitrile,

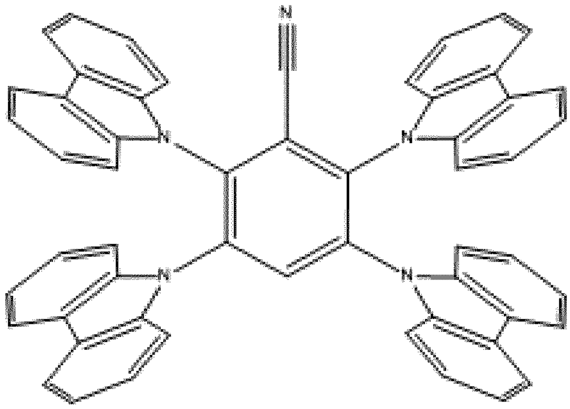

(2,3,5,6-tetra(9H-carbazol-9-yl)benzonitrile),

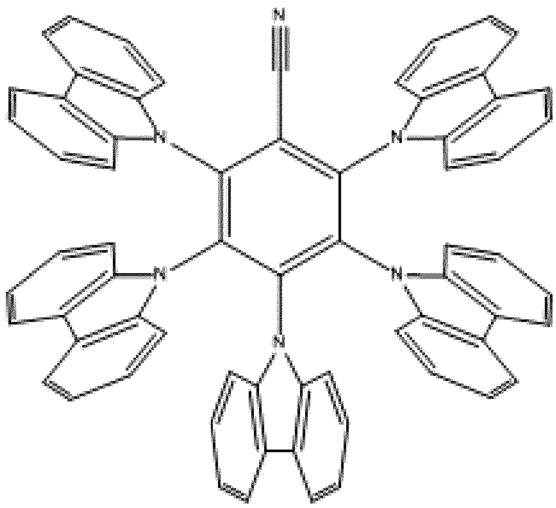

(2,3,4,5,6-penta(9H-carbazol-9-yl)benzonitrile),

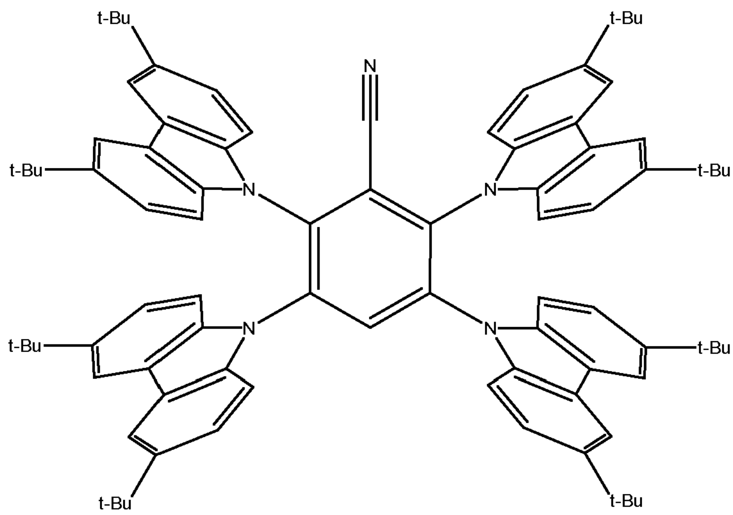

(2,3,5,6-tetrakis(3,6-di-tert-butyl-9H-carbazol-9-yl)benzonitrile),

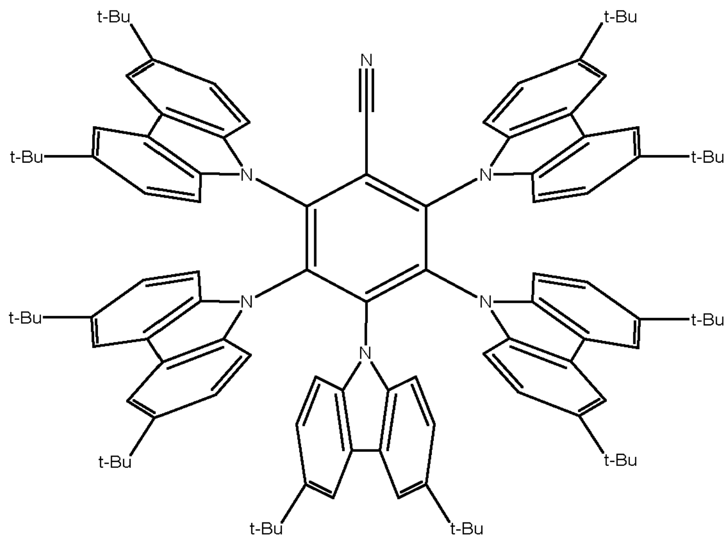

(2,3,4,5,6-pentakis(3,6-di-tert-butyl-9H-carbazol-9-yl)benzonitrile).

TADF molecules described herein, but not in accordance with the presently claimed invention can be, for example,

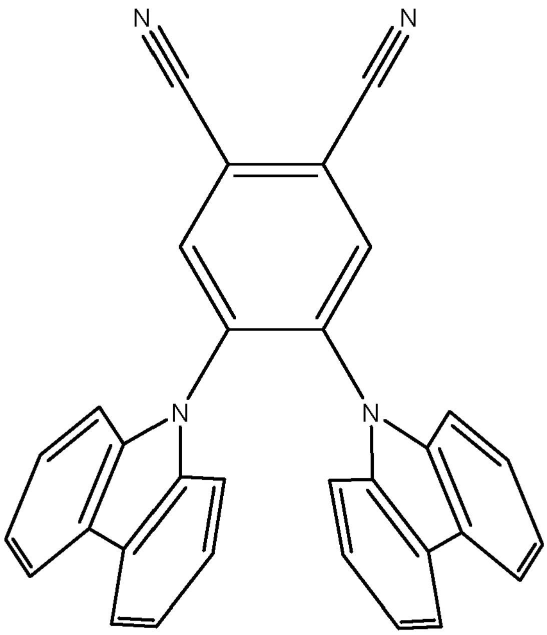

(4, 5-di(9H-carbazol-9-yl)phthalonitrile),

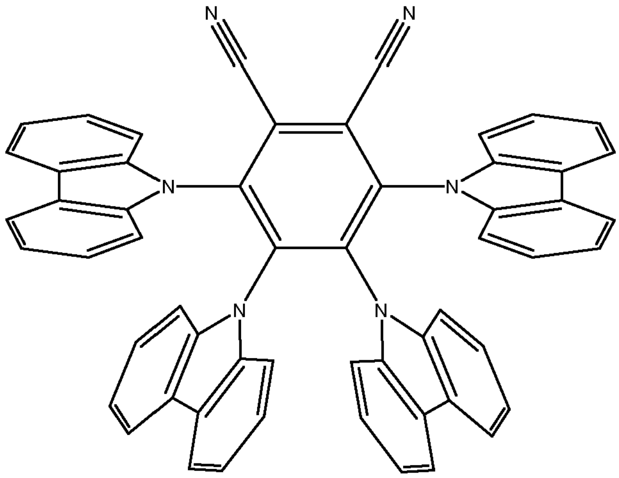

(3,4,5,6-tetra(9H-carbazol-9-yl)phthalonitrile),

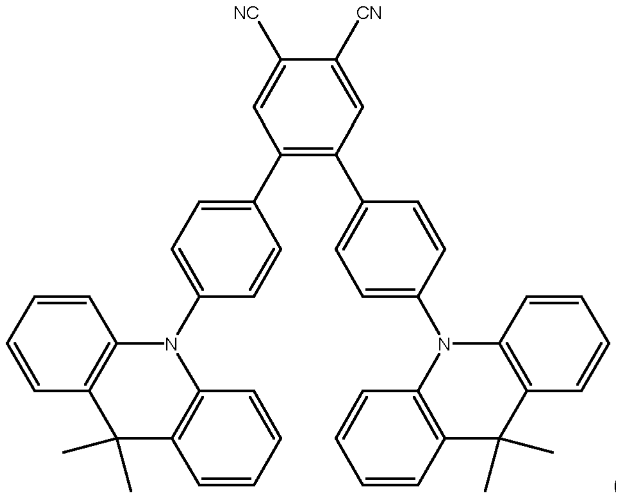

(4,4"-bis(9,9-dimethylacridin-10(9H)-yl)-[1,1':2',1"-terphenyl]-4',5'-dicarbonitrile), or any suitable structural analogs or homologs thereof.

TADF molecules described herein, but not in accordance with the presently claimed invention can be, for example,

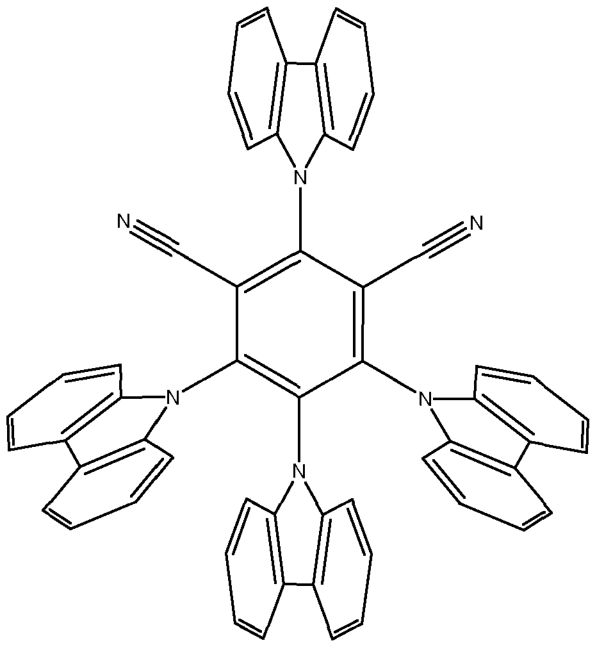

(2, 4, 5, 6-tetra(9H-carbazol-9-yl)isophthalonitrile),

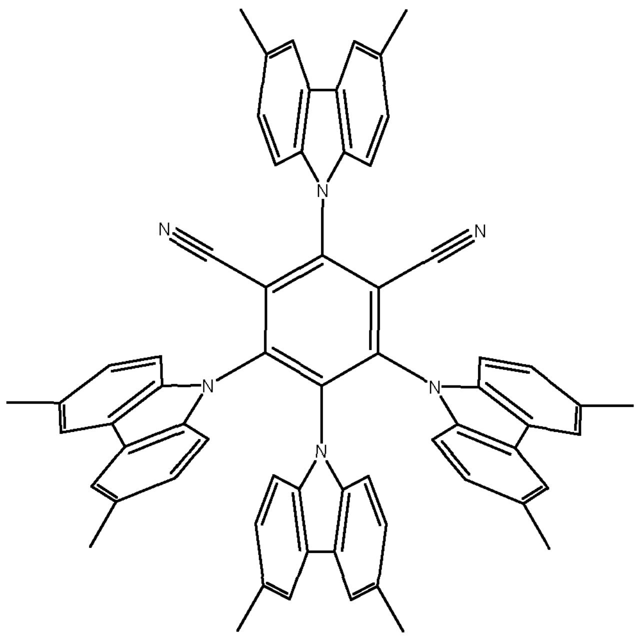

(2, 4, 5, 6-tetraki s(3, 6-dimethyl-9H-carb azol-9-yl)isophthalonitrile),

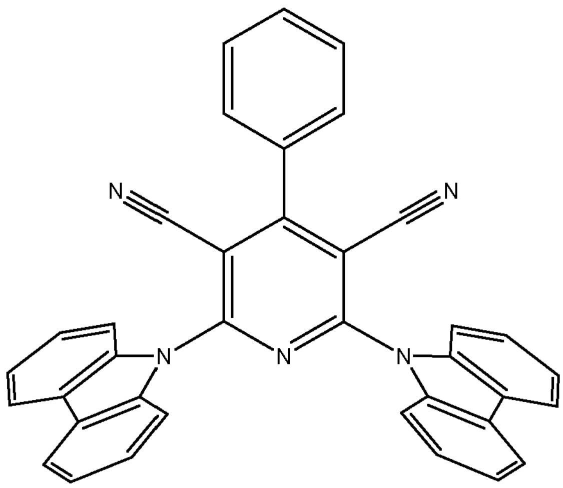

(2,6-di(9H-carbazol-9-yl)-4-phenylpyridine-3,5-dicarbonitrile), or any suitable structural analogs or homologs thereof.

TADF molecules described herein, but not in accordance with the presently claimed invention can be, for example,

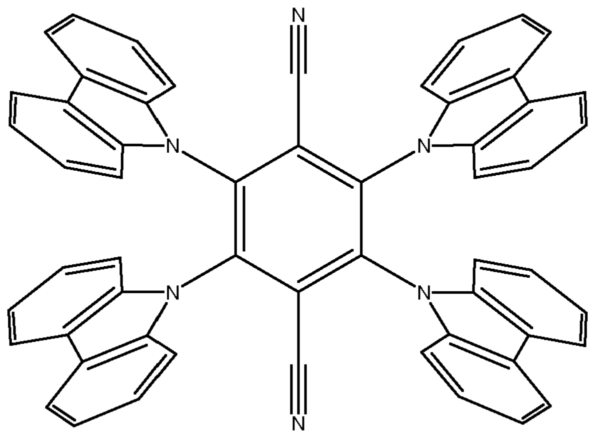

(2,3,5,6-tetra(9H-carbazol-9-yl)terephthalonitrile),

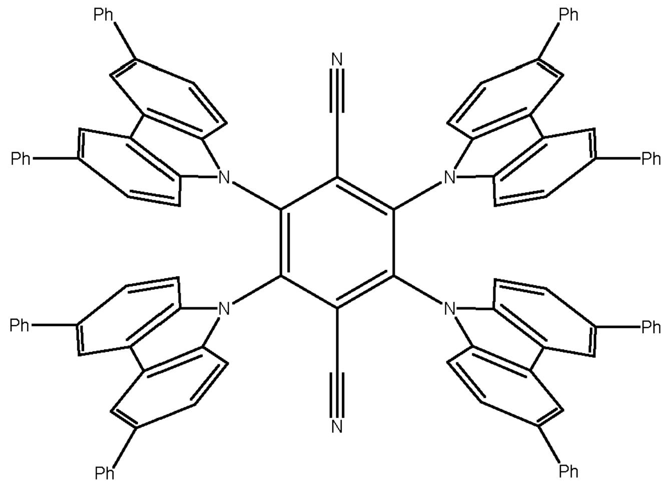

(2,3,5,6-tetrakis(3,6-diphenyl-9H-carbazol-9-yl)terephthalonitrile), or any suitable structural analogs or homologs thereof.

TADF molecules described herein, but not in accordance with the presently claimed invention can be, for example,

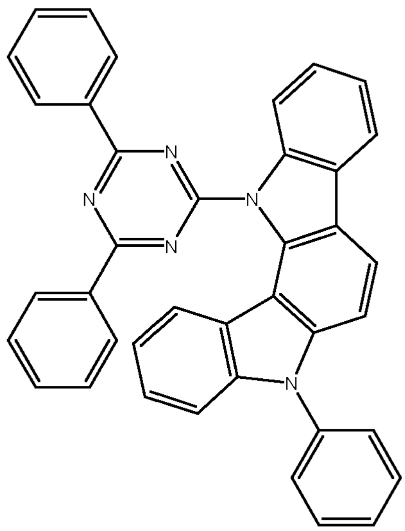

(12-(4,6-diphenyl-1,3,5-triazin-2-yl)-5-phenyl-5,12-dihydroindolo[3,2-a]carbazole),

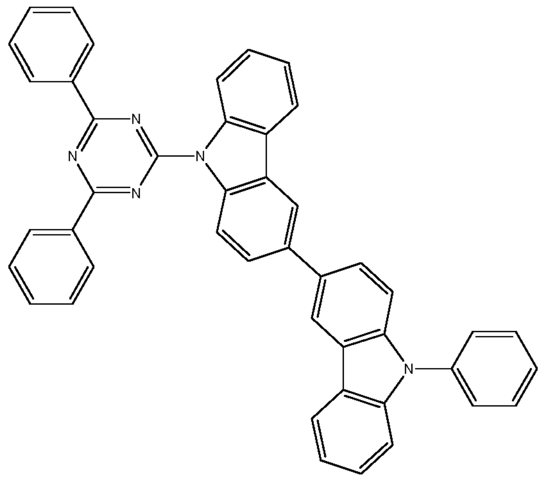

(9-(4,6-diphenyl-1,3,5 -triazin-2-yl)-9'-phenyl-9H,9'H-3,3'-bicarbazole),

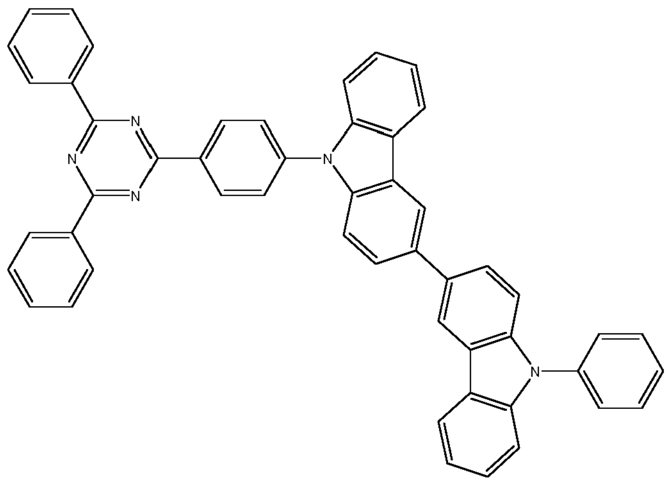

(9-(4-(4,6-diphenyl-1,3, 5-triazin-2-yl)phenyl)-9'-phenyl-9H,9'H-3,3'-bicarbazole),

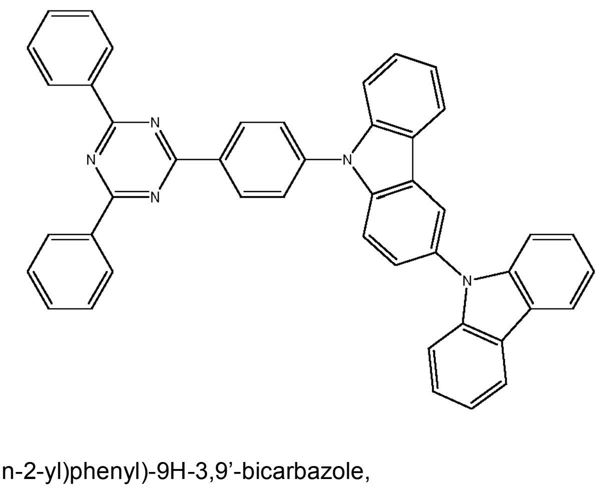

(9-(4-(4,6-diphenyl-1,3,5-triazin-2-yl)phenyl)-9H-3,9'-bicarbazole,

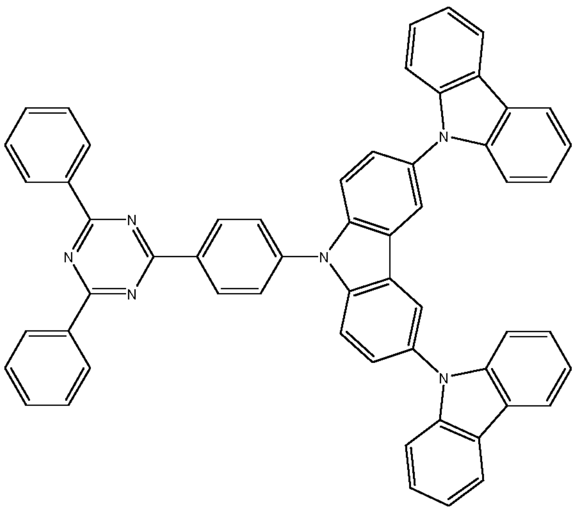

(9’-(4-(4,6-diphenyl-1,3,5-triazin-2-yl)phenyl)-9’H-9,3’:6’,9"-tercarbazole),

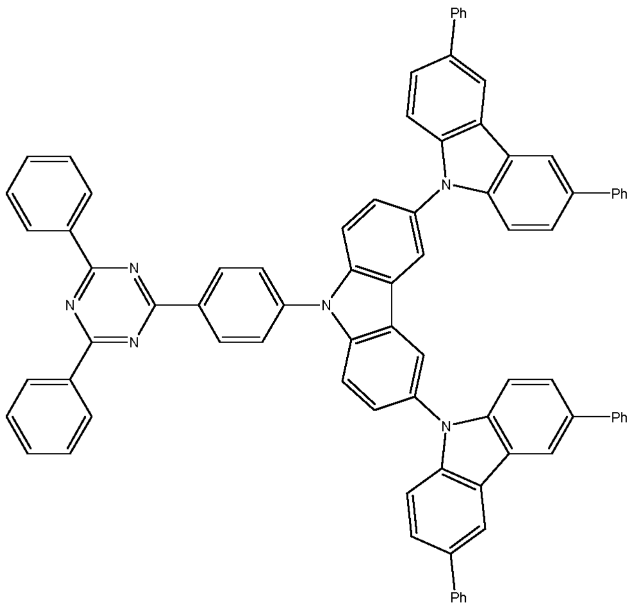

(9’-(4-(4,6-diphenyl-1,3,5-triazin-2-yl)phenyl)-3,3",6,6"-tetraphenyl-9’H-9,3’:6’,9"-tercarbazole),

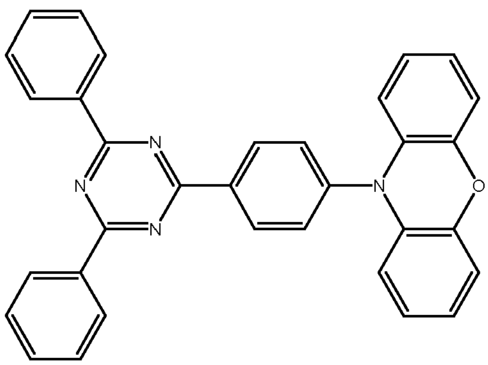

(10-(4-(4,6-diphenyl-1,3,5-triazin-2-yl)phenyl)-10H-phenoxazine),

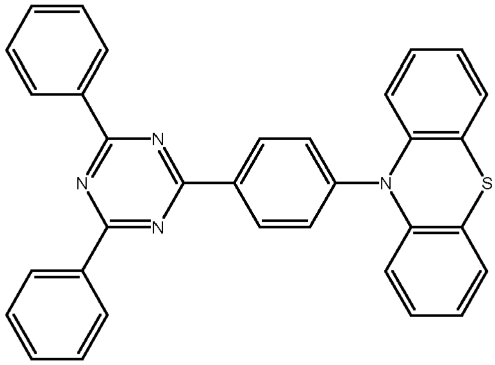

(10-(4-(4,6-diphenyl-1,3,5-triazin-2-yl)phenyl)-10H-phenothiazine),

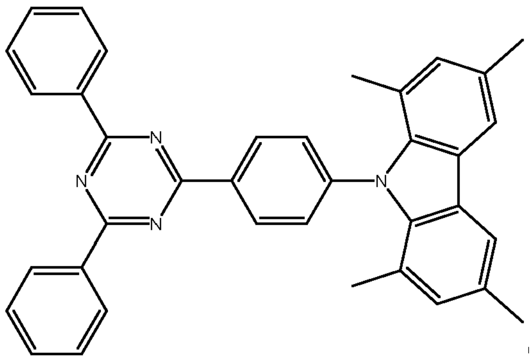

(9-(4-(4, 6-diphenyl-1,3, 5 -triazin-2-yl)phenyl)-1,3,6,8-tetramethyl-9H-carbazole),

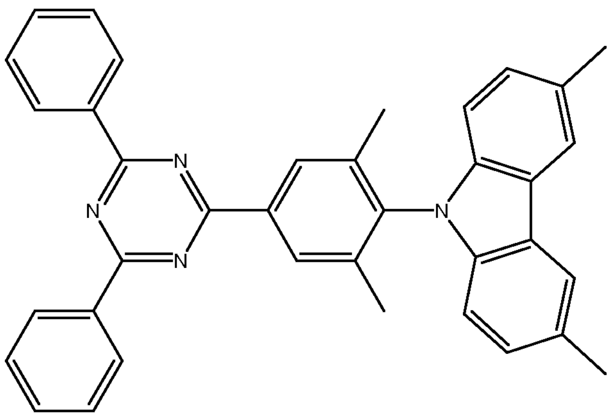

(9-(4-(4,6-diphenyl-1,3,5-triazin-2-yl)-2,6-dimethylphenyl)-3,6-dimethyl-9H-carbazole),

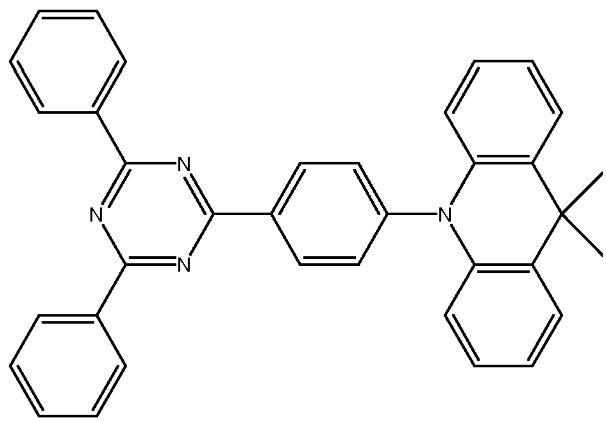

(10-(4-(4,6-diphenyl-1,3,5-triazin-2-yl)phenyl)-9,9-dimethyl-9,10-dihydroacridine),

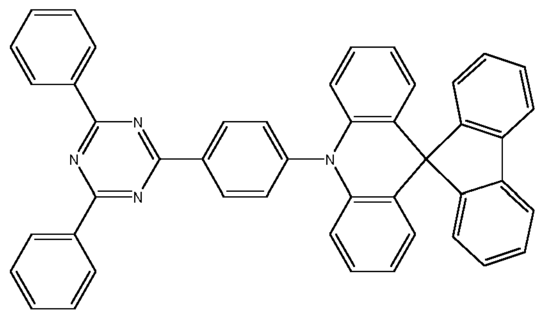

(10-(4-(4,6-diphenyl-1,3,5-triazin-2-yl)phenyl)-1 0H-spiro[acridine-9,9'-fluorene]),

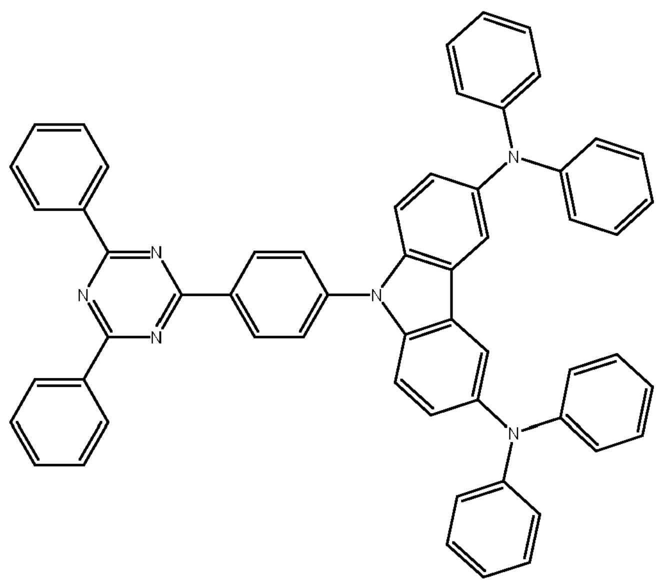

(9-(4-(4,6-diphenyl-1,3,5-triazin-2-yl)phenyl)-N3,N3,N6,N6-tetraphenyl-9H-carbazole-3,6-diamine),

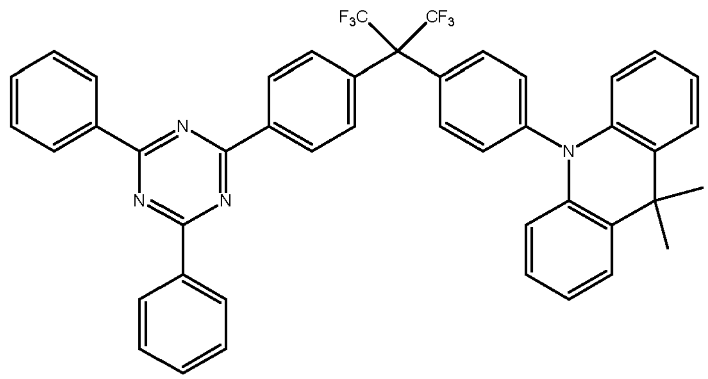

(10-(4-(2-(4-(4,6-diphenyl-1,3,5-triazin-2-yl)phenyl)-1,1,1,3,3,3-hexafluoropropan-2-yl)phenyl)-9,9-dimethyl-9,10-dihydroacridine), or any suitable structural analogs or homologs thereof.

TADF molecules described herein, but not in accordance with the presently claimed invention can be, for example,

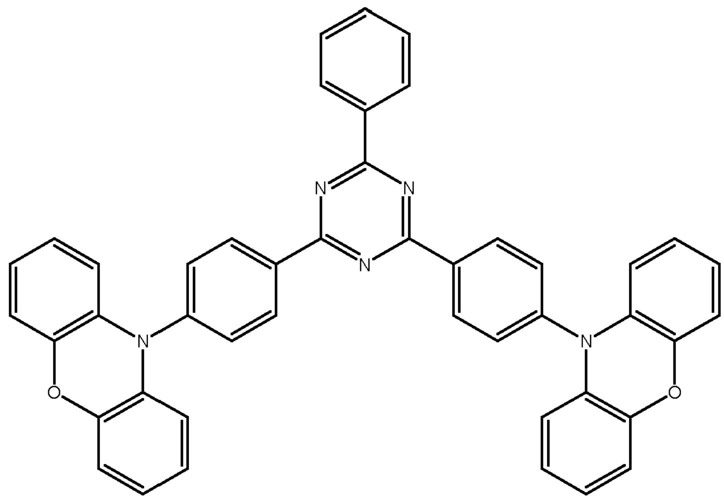

(10,10'-((6-phenyl-1,3,5-triazine-2,4-diyl)bis(4,1-phenylene))bis(10H-phenoxazine)),

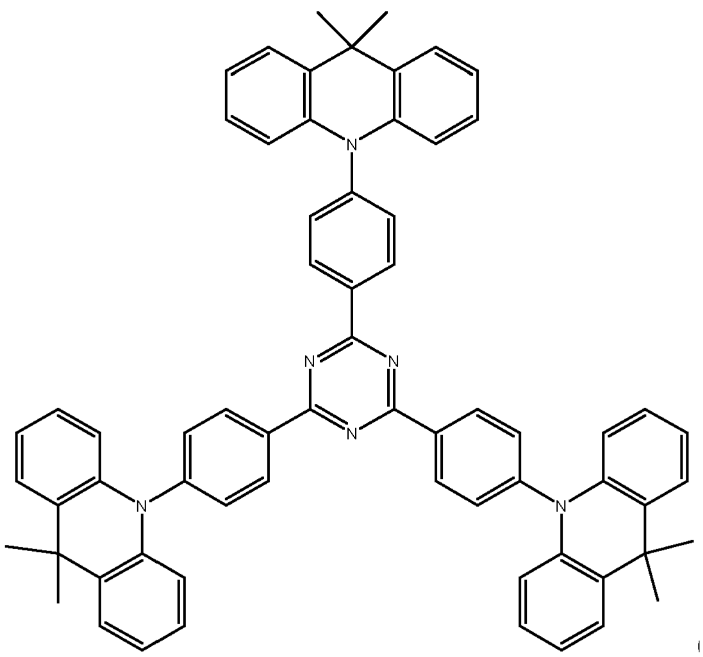

(2,4,6-tris(4-(9,9-dimethylacridin-10(9H)-yl)phenyl)-1,3,5-triazine)),

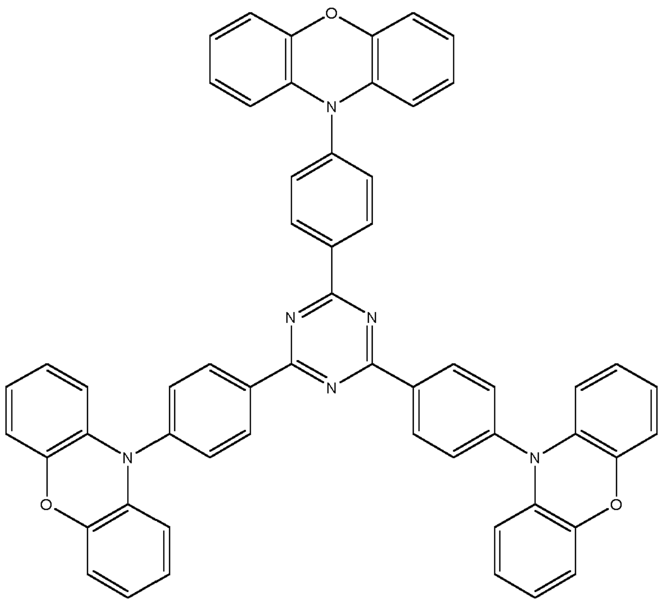

(2,4,6-tris(4-(10H-phenoxazin-10-yl)phenyl)-1,3,5-triazine), or any suitable structural analogs or homologs thereof.

TADF molecules described herein, but not in accordance with the presently claimed invention can be, for example,

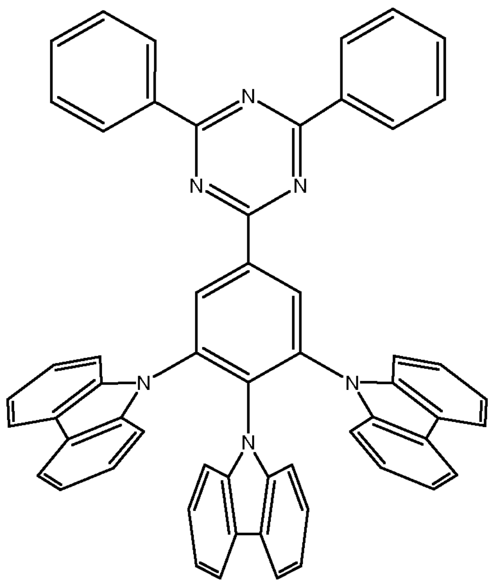

(9,9',9"-(5-(4,6-diphenyl-1,3,5-triazin-2-yl)benzene-1,2,3-triyl)tris(9H-carbazole),

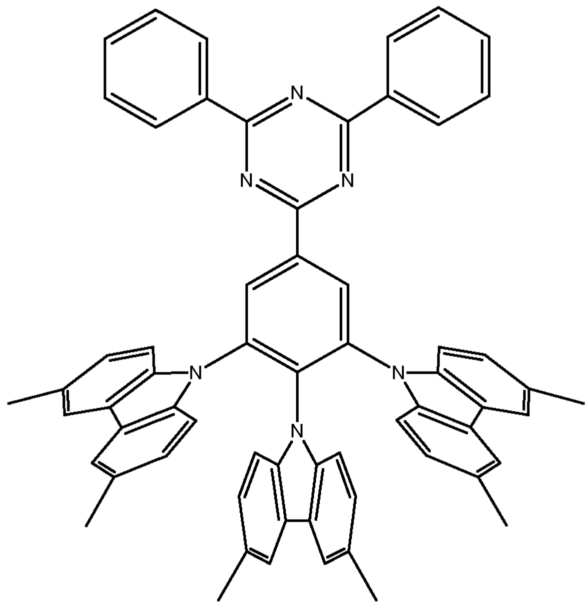

(9,9',9"-(5-(4,6-diphenyl-1,3,5-triazin-2-yl)benzene-1,2,3-triyl)tris(3,6-dimethyl-9H-carbazole)), or any suitable structural analogs or homologs thereof.

TADF molecules described herein, but not in accordance with the presently claimed invention can be, for example,

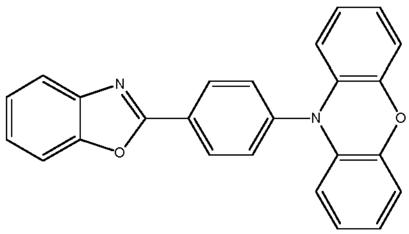

(10-(4-(benzo[d]oxazol-2-yl)phenyl)-10H-phenoxazine),

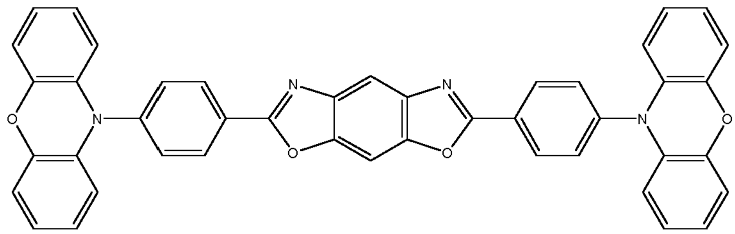

(2,6-bis(4-(10H-phenoxazin-10-yl)phenyl)benzo[1,2-d:5,4-d']bis(oxazole)), or any suitable structural analogs or homologs thereof.

TADF molecules described herein, but not in accordance with the presently claimed invention can be, for example,

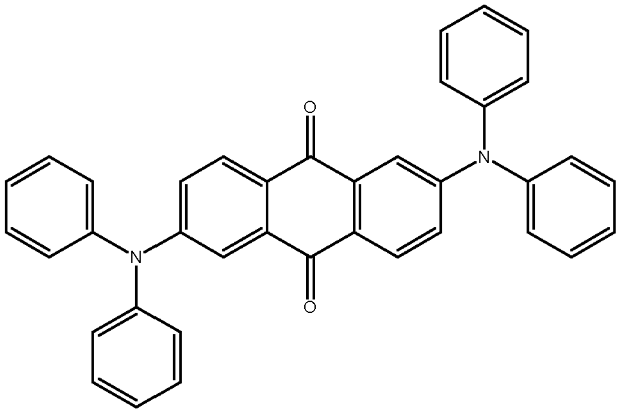

(2,6-bis(diphenylamino)anthracene-9,10-dione),

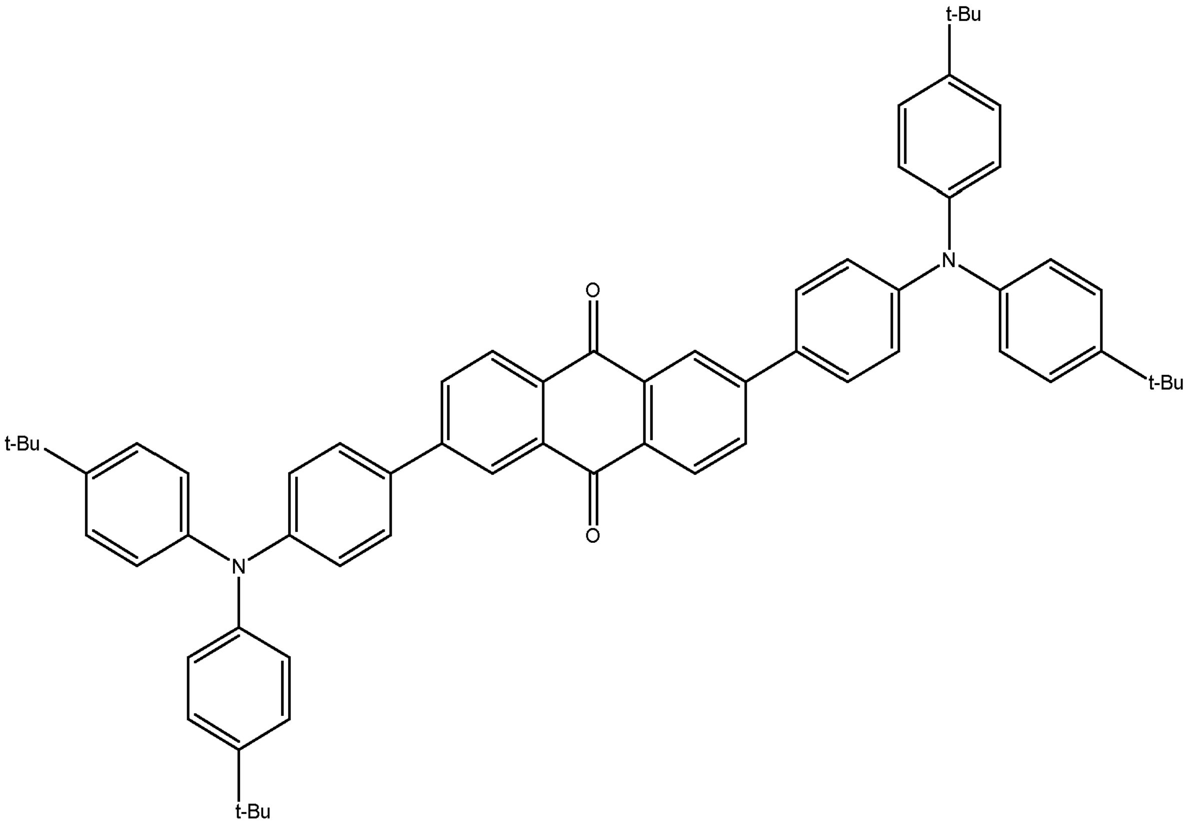

(2,6-bis(4-(bis(4-(tert-butyl)phenyl)amino)phenyl)anthracene-9,10-dione), or any suitable structural analogs or homologs thereof.

TADF molecules described herein, but not in accordance with the presently claimed invention can be, for example,

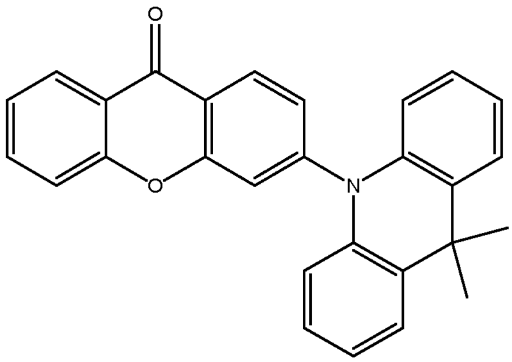

(3-(9,9-dimethylacridin-10(9H)-yl)-9H-xanthen-9-one),

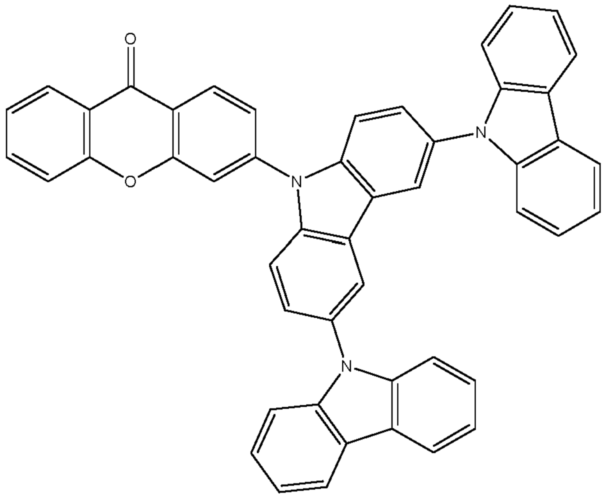

(3-(9'H-[9,3':6',9"-tercarbazol]-9'-yl)-9H-xanthen-9-one), or any suitable structural analogs or homologs thereof.

TADF molecules described herein, but not in accordance with the presently claimed invention can be, for example,

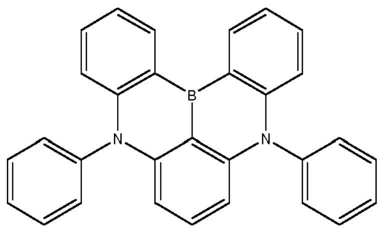

(5,9-diphenyl-5,9-dihydro-5,9-diaza-13b-boranaphtho[3,2,1-de] anthracene),

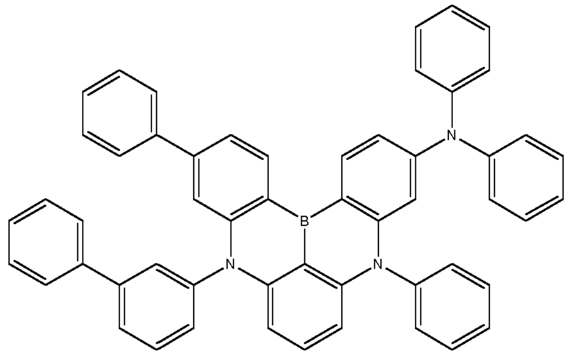

(9-([1,1'-biphenyl]-3-yl)-N,N,5,11-tetraphenyl-5,9-dihydro-5,9-diaza-13b-boranaphtho[3,2,1-de]anthracen-3-amine), or any suitable structural analogs or homologs thereof.

TADF molecules described herein, but not in accordance with the presently claimed invention can be, for example,

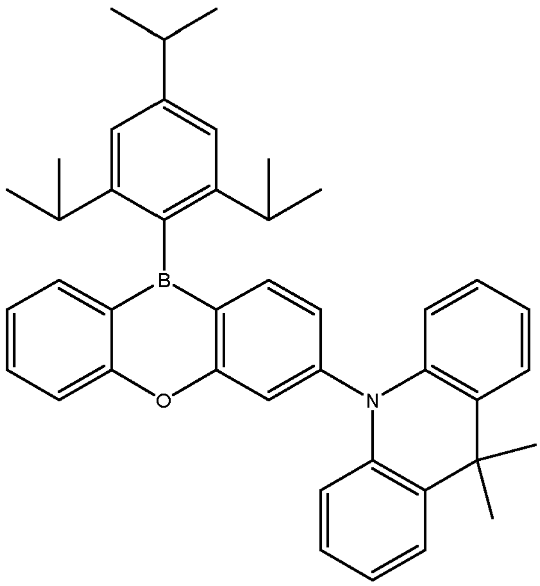

(9,9-dimethyl-10-(10-(2,4,6-triisopropylphenyl)-10H-dibenzo[b,e][1,4]oxaborinin-3-yl)-9,10-dihydroacridine), or any suitable structural analog or homolog thereof.

TADF molecules described herein, but not in accordance with the presently claimed invention, can be, for example,

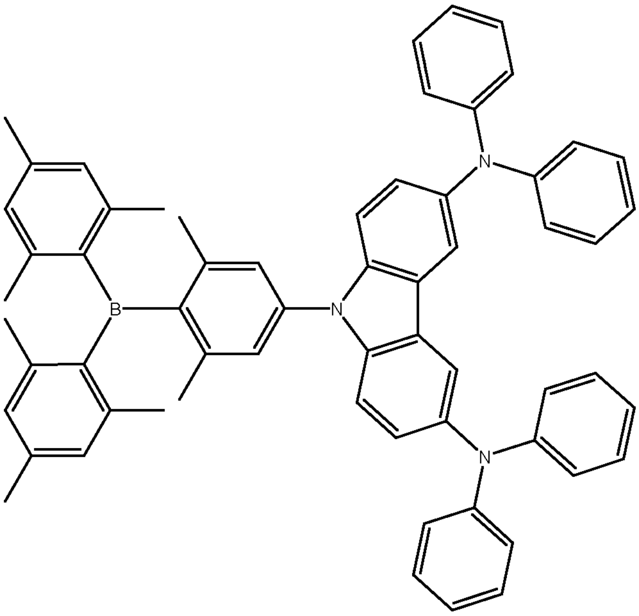

(9-(4-(dimesitylboraneyl)-3,5 - dimethylphenyl)-N3,N3,N6,N6-tetraphenyl-9H-carbazole-3,6-diamine), or any suitable structural analog or homolog thereof.

TADF molecules described herein, but not in accordance with the presently claimed invention can be, for example,

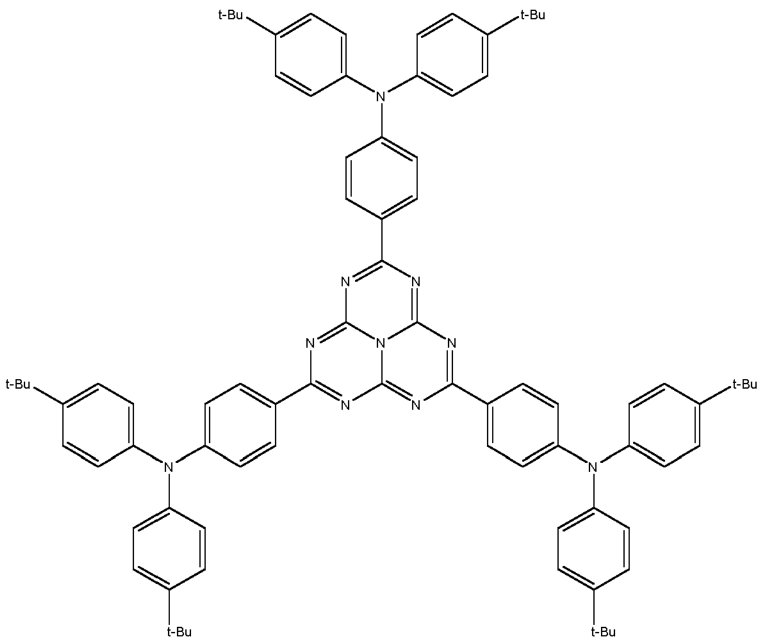

(4,4',4"-(1,3,3a1,4,6,7,9-heptaazaphenalene-2,5,8-triyl)tris(N,N-bis(4-(tert-butyl)phenyl)aniline)), or any suitable structural analog or homolog thereof.

TADF molecules described herein, but not in accordance with the presently claimed invention can be, for example,

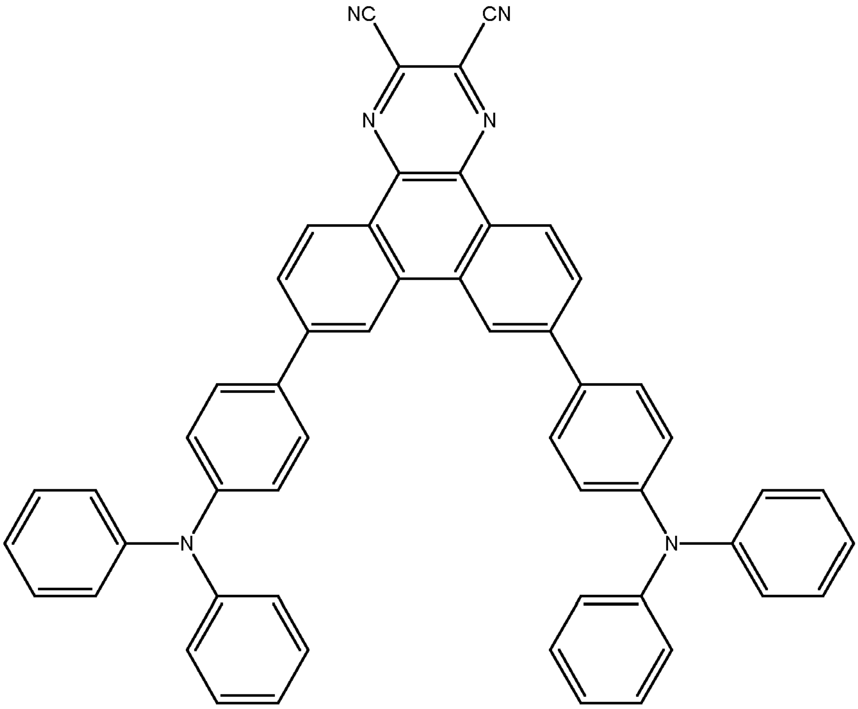

(7,10-bis(4-(diphenylamino)phenyl)dibenzo[f,h]quinoxaline-2,3-dicarbonitrile)), or any suitable structural analog or homolog thereof.

TADF molecules described herein, but not in accordance with the presently claimed invention can be, for example,

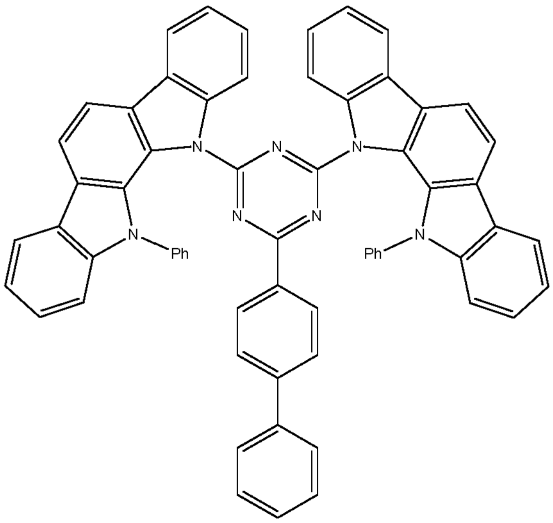

(12,12'-(6-([1,1'-biphenyl]-4-yl)-1,3,5-triazine-2,4-diyl)bis(11-phenyl-11,12-dihydroindolo[2,3-a]carbazole)), or any suitable structural analog or homolog thereof.

TADF molecules described herein, but not in accordance with the presently claimed invention can be, for example,

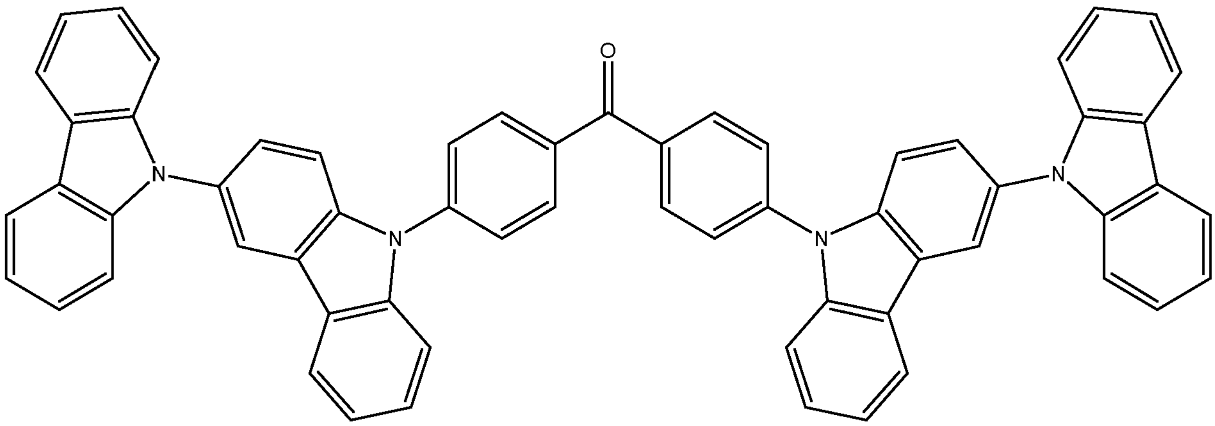

(bis(4-(9H-[3,9'-bicarbazol]-9-yl)phenyl)methanone), or any suitable structural analog or homolog thereof.

TADF molecules described herein, but not in accordance with the presently claimed invention can be, for example,

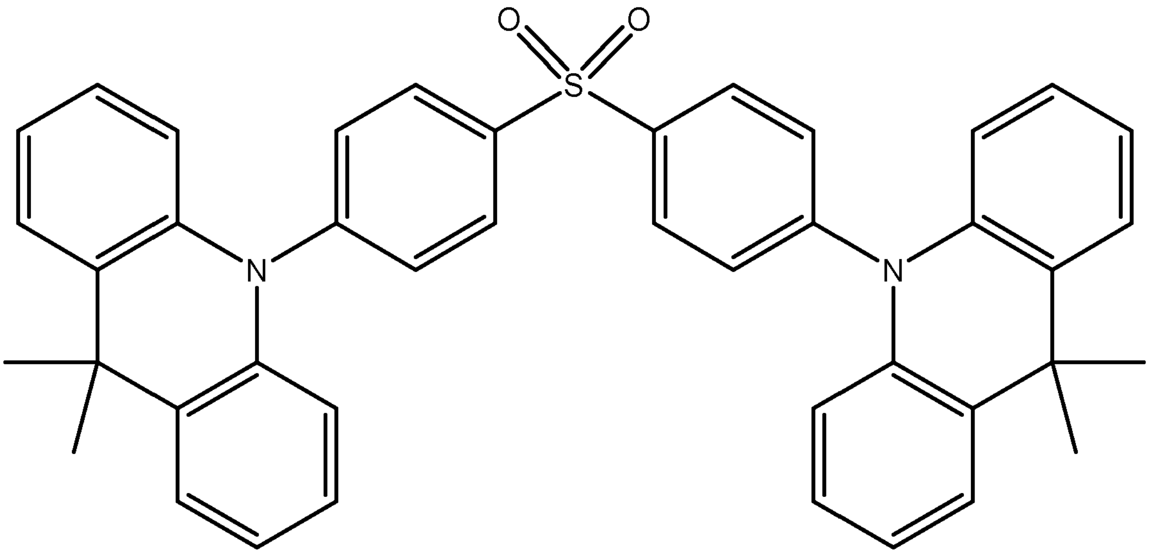

(10,10'-(sulfonylbis(4,1-phenylene))bis(9,9-dimethyl-9,10-dihydroacridine)), or any suitable structural analog or homolog thereof.

TADF molecules described herein, but not in accordance with the presently claimed invention can be, for example,

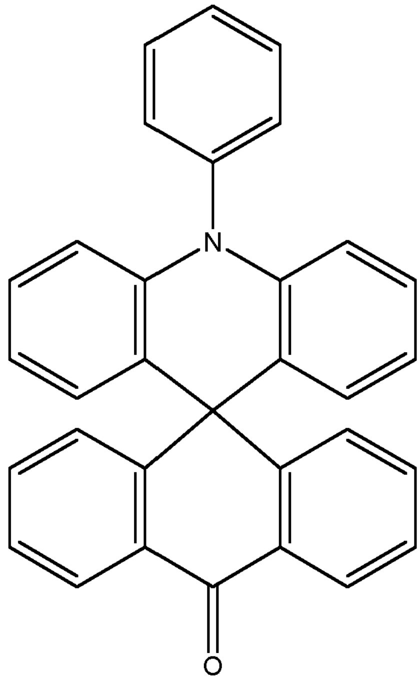

(10-phenyl-10H,10'H-spiro[acridine-9,9'-anthracen]-10'-one), or any suitable structural analog or homolog thereof.

QDs used in accordance with varying aspects of the present disclosure can have a size ranging from 2 - 100 nm and include core material comprising:

IIA-VIA (2-16) material, consisting of a first element from group 2 of the periodic table and a second element from group 16 of the periodic table and also including ternary and quaternary materials and doped materials. Nanoparticle material includes but is not restricted to: MgS, MgSe, MgTe, CaS, CaSe, CaTe, SrS, SrSe, SrTe, BaS, BaSe, BaTe;
IIB-VIA (12-16) material consisting of a first element from group 12 of the periodic table and a second element from group 16 of the periodic table and also including ternary and quaternary materials and doped materials. Nanoparticle material includes but is not restricted to: ZnS, ZnSe, ZnTe, CdS, CdSe, CdTe, HgS, HgSe, HgTe;
II-V material, consisting of a first element from group 12 of the periodic table and a second element from group 15 of the periodic table and also including ternary and quaternary materials and doped materials. Nanoparticle material includes but is not restricted to: $Zn_3P_2$, $Zn_3As_2$, $Cd_3P_2$, $Cd_3As_2$, $Cd_3N_2$, $Zn_3N_2$;
III-V material, consisting of a first element from group 13 of the periodic table and a second element from group 15 of the periodic table and also including ternary and quaternary materials and doped materials. Nanoparticle material includes but is not restricted to: BP, AlP, AlAs, AlSb; GaN, GaP, GaAs, GaSb; InN, InP, InAs, InSb, AlN, BN;
III-IV material, consisting of a first element from group 13 of the periodic table and a second element from group 14 of the periodic table and also including ternary and quaternary materials and doped materials. Nanoparticle material includes but is not restricted to: $B_4C$, $Al_4C_3$, $Ga_4C$;
III -VI material, consisting of a first element from group 13 of the periodic table and a second element from group 16 of the periodic table and also including ternary and quaternary materials. Nanoparticle material includes but is not restricted to: $Al_2S_3$, $Al_2Se_3$, $Al_2Te_3$, $Ga_2S_3$, $Ga_2Se_3$, GeTe; $In_2S_3$, $In_2Se_3$, $Ga_2Te_3$, $In_2Te_3$, InTe;
IV-VI material, consisting of a first element from group 14 of the periodic table and a second element from group 16 of the periodic table, and also including ternary and quaternary materials and doped materials. Nanoparticle material includes but is not restricted to: PbS, PbSe, PbTe, SnS, SnSe, SnTe;
V-VI material, consisting of a first element from group 15 of the periodic table and a second element from group 16 of the periodic table, and also including ternary and quaternary materials and doped materials. Nanoparticle material includes but is not restricted to: $Bi_2Te_3$, $Bi_2Se_3$, $Sb_2Se_3$, $Sb_2Te_3$; and
Nanoparticle material, consisting of a first element from any group in the transition metal of the periodic table, and a second element from group 16 of the periodic table and also including ternary and quaternary materials and doped materials. Nanoparticle material includes but is not restricted to: NiS, CrS, $CuInS_2$, $CuInSe_2$, $CuGaS_2$, $CuGaSe_2$, $CuIn_xGa_{1-x}S_ySe_{2-y}$ (where $0 \le x \le 1$ and $0 \le y \le 2$), $AgInS_2$.

By the term doped nanoparticle for the purposes of specifications and claims, refers to nanoparticles of the above and a dopant comprised of one or more main group or rare earth elements, this most often is a transition metal

or rare earth element, such as but not limited to zinc sulfide with manganese, such as ZnS nanoparticles doped with $Mn^{2+}$.

The term "ternary material," for the purposes of specifications and claims, refers to QDs of the above but a three-component material. The three components are usually compositions of elements from the as mentioned groups Example being $(Zn_xCd_{1-x}S)_mL_n$ nanocrystal (where L is a capping agent).

The term "quaternary material," for the purposes of specifications and claims, refers to nanoparticles of the above but a four-component material. The four components are usually compositions of elements from the as mentioned groups Example being $(Zn_xCd_{1-x}S_ySe_{1-y})_mL_n$ nanocrystal (where L is a capping agent).

The material used on any shell or subsequent numbers of shells grown onto the core particle in most cases will be of a similar lattice type material to the core material i.e. have close lattice match to the core material so that it can be epitaxially grown on to the core, but is not necessarily restricted to materials of this compatibility. The material used on any shell or subsequent numbers of shells grown on to the core present in most cases will have a wider bandgap than the core material but is not necessarily restricted to materials of this compatibility. The materials of any shell or subsequent numbers of shells grown on to the core can include material comprising:

IIA-VIA (2-16) material, consisting of a first element from group 2 of the periodic table and a second element from group 16 of the periodic table and also including ternary and quaternary materials and doped materials. Nanoparticle material includes but is not restricted to: MgS, MgSe, MgTe, CaS, CaSe, CaTe, SrS, SrSe, SrTe;

IIB-VIA (12-16) material, consisting of a first element from group 12 of the periodic table and a second element from group 16 of the periodic table and also including ternary and quaternary materials and doped materials. Nanoparticle material includes but is not restricted to: ZnS, ZnSe, ZnTe, CdS, CdSe, CdTe, HgS, HgSe, HgTe;

II-V material, consisting of a first element from group 12 of the periodic table and a second element from group 15 of the periodic table and also including ternary and quaternary materials and doped materials. Nanoparticle material includes but is not restricted to: $Zn_3P_2$, $Zn_3As_2$, $Cd_3P_2$, $Cd_3As_2$, $Cd_3N_2$, $Zn_3N_2$;

III -V material, consisting of a first element from group 13 of the periodic table and a second element from group 15 of the periodic table and also including ternary and quaternary materials and doped materials. Nanoparticle material includes but is not restricted to: BP, AlP, AlAs, AlSb; GaN, GaP, GaAs, GaSb; InN, InP, InAs, InSb, AlN, BN;

III-IV material, consisting of a first element from group 13 of the periodic table and a second element from group 14 of the periodic table and also including ternary and quaternary materials and doped materials. Nanoparticle material includes but is not restricted to: $B_4C$, $Al_4C_3$, $Ga_4C$;

III -VI material, consisting of a first element from group 13 of the periodic table and a second element from group 16 of the periodic table and also including ternary and quaternary materials. Nanoparticle material includes but is not restricted to: $Al_2S_3$, $Al_2Se_3$, $Al_2Te_3$, $Ga_2S_3$, $Ga_2Se_3$, $In_2S_3$, $In_2Se_3$, $Ga_2Te_3$, $In_2Te_3$;

IV -VI material, consisting of a first element from group 14 of the periodic table and a second element from group 16 of the periodic table and also including ternary and quaternary materials and doped materials. Nanoparticle material includes but is not restricted to: PbS, PbSe, PbTe, SnS, SnSe, SnTe;

V-VI material, consisting of a first element from group 15 of the periodic table and a second element from group 16 of the periodic table, and also including ternary and quaternary materials and doped materials. Nanoparticle material includes but is not restricted to: $Bi_2Te_3$, $Bi_2Se_3$, $Sb_2Se_3$, $Sb_2Te_3$; and

Nanoparticle material, consisting of a first element from any group in the transition metal of the periodic table, and a second element from group 16 of the periodic table and also including ternary and quaternary materials and doped materials. Nanoparticle material includes but is not restricted to: NiS, CrS, $CuInS_2$, $CuInSe_2$, $CuGaS_2$, $CuGaSe_2$, $CuIn_xGa_{1-x}S_ySe_{2-y}$ (where $0 \le x \le 1$ and $0 \le y \le 2$), $AgInS_2$.

As illustrated in FIG. 4, the degree of separation or distance between the TADF molecule and a QD can be controlled by using QD capping ligands. Specifically, the longer the capping ligand, the greater the distance between the TADF molecule and the QD. Generally, a Lewis acid is used as a capping ligand. In some instances, capping ligands used in accordance with various aspects of the present disclosure can be primary, secondary or tertiary amines or ammonium compounds having one or more linear or branched $C_1$-$C_{24}$ alkyl groups; or one or more $C_3$-$C_{18}$ aromatic, polycyclic aromatic, cycloalkane, cycloalkene, cycloalkyne, polycycloalkane, polycycloalkene, or polycycloalkyne groups. In some instances, capping ligands used in accordance with various aspects of the present disclosure can be primary, secondary or tertiary phosphines or phosphonium compounds having one or more linear or branched $C_1$-$C_{24}$ alkyl groups; or one or more $C_3$-$C_{18}$ aromatic, polycyclic aromatic, cycloalkane, cycloalkene, cycloalkyne, polycycloalkane, polycycloalkene, or polycycloalkyne groups. In some instances, capping ligands used in accordance with various aspects of the present disclosure can be a carboxylic acid having a linear or branched $C_1$-$C_{24}$ alkyl group; or a $C_3$-$C_{18}$ aromatic, polycyclic aromatic, cycloalkane, cycloalkene, cycloalkyne, polycycloalkane, polycycloalkene, or polycycloalkyne groups. In some instances, capping ligands used in accordance with various aspects of the present disclosure can be an alcohol, polyol, a thiol, a selenol or a tellurium equivalent (R-Te-H) having a linear or branched $C_1$-$C_{24}$ alkyl group; or a $C_3$-$C_{18}$ aromatic, polycyclic aromatic, cycloalkane, cycloalkene, cycloalkyne, polycycloalkane, polycycloalkene, or polycycloalkyne groups. In some instances, capping ligands used in accordance with various aspects of the present disclosure can be an entropic ligand. As used herein, "entropic ligand" refers to a ligand having an irregularly branched alkyl chain. Examples of suitable entropic ligands include, but are not restricted to: irregularly branched thiols, for example, 2-methylbutanethiol, and 2-ethylhexanethiol; and irregularly branched alkanoic acids, for example, 4-methyloctanoic acid, 4-ethyloctanoic acid, 2-butyloctanoic acid, 2-heptyldecanoic acid, and 2-hexyldecanoic acid. Entropic ligands may improve nanoparticle processability, while retaining or improving their performance in devices.

To maximise FRET, smaller QDs emitting at a given wavelength may be desirable. For example, QDs based on InP, which has a narrower bulk band gap and larger Bohr radius than core QDs such as CdSe, may be advantageous. An InP QD core emitting at, for example, 620 nm, will typically have a smaller diameter than a CdSe QD core emitting at the same wavelength.

For example, the overlap along with the values used to estimate the critical distance for a system having a QD, exhibiting a maximum photoluminescence ($PL_{max}$) of 528 nm and a full-width at half maximum (FWHM) of 39 nm, and a TADF molecule, exhibiting a $PL_{max}$ of 548 nm and a FWHM of 92 nm, are presented in FIGS. 5-6 and Table 1. With specific reference to FIG. 6, this graph shows the spectral overlap integrand for these two materials. Maximizing this overlap is an important parameter which, as shown in Equation 1 above, will lead to an increased critical distance for FRET and so an increasing efficiency of energy transfer.

TABLE 1.

| Parameter | Value |
|---|---|
| QD Extinction Coefficient at $\lambda_{max}$ | $2.2 \times 10^5$ $M^{-1}cm^{-1}$ |
| Dipole orientation factor, $\kappa^2$ | 2/3 |
| Refractive index | 1.7 |
| QY donor (TADF molecule) | 0.52 |
| Critical distance, $R_0$ | 4.7 nm |

From the above, a critical distance of 4.7 nm is obtained for a QD, exhibiting a maximum photoluminescence ($PL_{max}$) of 528 nm and a full-width at half maximum (FWHM) of 39 nm, and a TADF molecule, exhibiting a $PL_{max}$ of 548 nm and a FWHM of 92 nm. One of ordinary skill in the art will readily understand the critical distance is a function of the particular QD and TADF molecule used in a system.

*Maximization of QD Oscillator Strength*

The oscillator strength of the band gap transition of a QD, $f_{gap}$, describes the probability of fluorescence. Thus, for two-dopant system applications it may be desirable to incorporate QDs having a high oscillator strength. In the strong quantum confinement regime, oscillator strength varies only weakly of with QD size, since the electron and hole wave functions overlap completely, independently of particle size, [M.D. Leistikow, J. Johansen, A.J. Kettelarij, P. Lodahl and W.L. Vos, Phys. Rev. B, 2009, 79, 045301] whereas for QDs beyond the strong quantum confinement regime the oscillator strength should increase with increasing particle size. [K.E. Gong, Y. Zeng and D.F. Kelley, J. Phys. Chem. C, 2013, 117, 20268].

QDs comprising a core comprising, for example, InP and emitting within the visible spectrum would have a radius well within the strong confinement regime and the oscillator strength would therefore largely be independent of particle size. In some instances, the shape of the QD may influence oscillator strength. In some instances, the QDs can be substantially spherical or ovoid. In other instances, the QDs can be substantially conical. In yet other instances, the QDs can be substantially cylindrical. In yet other instances, the QDs can be substantially rod-shaped. In yet other instances, the QDs can be in the form or nanorods, nanotubes, nanofibers, nanosheets, dendrimers, stars, tetrapods, disks, or similar physical configurations.

*Increasing QD Absorption*

A high QD absorption cross-section is desirable to maximise the FRET process. In quantum rods, for example the emission wavelength is controlled by the length of the short axis, and the absorption cross-section depends predominantly on volume. The absorption cross-section of a nanoparticle, $a_a$, is defined in **Equation 2**:

$$\alpha_a(\hbar\omega) = \frac{n_b}{n}\alpha_b(\hbar\omega)|f(\hbar\omega)|^2 V$$

where $n_b$ and $a_b$ are the refractive index and the absorption coefficient of the bulk semiconductor, respectively, n is the refractive index of the surrounding medium, $|f(\hbar\omega)|^2$ is the local-field factor, and $V$ is the volume. Htoon *et al.* investigated the absorption cross-section of spherical (radius = 2.3 nm) QDs compared with that of elongated nanoparticles, quantum rods, with the same radius but lengths of 22, 36 and 44 nm. [H. Htoon, J.A. Hollingworth, A.V. Malko, R. Dickerson and V.I. Klimov, Appl. Phys. Lett., 2003, 82, 4776]. As well as the nanorods having a larger volume, $|f(\hbar\omega)|^2$ was found to almost twice as high for randomly oriented nanorods compared to the spherical nanoparticles. $|f(\hbar\omega)|^2$ can be increased yet further for aligned nanorods. Thus, a quantum rod architecture may be advantageous over a spherical QD geometry, in terms of increasing the QD absorption cross-section.

*Minimizing Excited State Lifetime*

For efficient FRET, it is advantageous to minimize the excited state lifetime of QDs. Fundamentally, the excited state lifetime of a QD relates to the degree of confinement. The higher the overlap between the electron and hole, the stronger the confinement and the shorter the radiative lifetime. QD architectures that maximise the electron-hole overlap may be beneficial for two-dopant systems in electroluminescent devices. In some instances, for a given core size, increasing the shell thickness on said core decreases the excited state lifetime of the QD. However, as previously discussed, a core-shell quantum dot having a relatively thick shell may not be desirable, the distance between the TADF molecule and the QD increases with increasing shell thickness. Thus, alternative methods to manipulate the degree of confinement in the QD may be required.

In a Type I core-shell QD, an abrupt offset of the energy levels may result in strong confinement, whereas compositional grading may lead to some delocalisation of the electrons and holes. For example, the confinement in an InP/ZnS QD, consisting of an InP core (bulk band gap, $E_g$, = 1.34 eV) overcoated with a ZnS shell ($E_g$ = 3.54 eV (cubic); 3.91 eV (hexagonal)), will be stronger than that in an InP/ZnSe core-shell QD (ZnSe $E_g$ = 2.82 eV). An example of a compositionally graded Type I QD would be $In_{1-x}P_{1-y}Zn_xS_y$, wherein x and y increase gradually from 0, at the centre of the QD, to 1, at the outer surface of the QD.

Where core-multi shell architectures are used, the relative thicknesses of the shells may influence the degree of confinement.

For core QDs of a particular material, the smaller the QD, the higher the overlap between the electron and hole and thus the shorter the radiative lifetime. Therefore, strategies to reduce the diameter of the QD core while maintaining a specific emission wavelength may be employed. This could include alloying a first semiconductor material with a second material having a smaller band gap at a similar lattice constant. For example, an InAsP nanoparticle, made by alloying InP with InAs, can emit at 630 nm and will have a smaller diameter than an InP nanoparticle emitting at the same wavelength. Also, for example, a CdSeS nanoparticle, made by alloying CdS with CdSe, can emit at 480 nm and will have a smaller diameter than a CdS nanoparticle emitting at the same wavelength.

In some instances, nanoparticle shape can affect the excited state lifetime. For example, the radiative lifetime of prolate CdSe QDs may be slightly shorter than that of spherical CdSe nanoparticles. [K. Gong, Y. Zang and D.F. Kelley, J. Phys. Chem. C, 2013, 117, 20268] Thus, rod-shaped QDs, *i.e.* quantum rods, may offer a shorter excited state lifetime than spherical QDs. Herein, "quantum rod" is used to describe a quantum dot having lateral dimensions, $x$ and $y$, and a length, $z$, wherein $z > x,y$. Alternatively, a shorter excited state lifetime may be provided by a 2-dimensional QD, wherein the quantum dot has lateral dimensions in the quantum confinement regime and a thickness between 1 - 5 monolayers.

## EXAMPLES

*Reference Example 7*

In this example an exemplary electroluminescent QD-LED device was constructed according to the energy level diagram of FIG. 7. Onto an indium tin oxide (ITO) substrate, which serves as the cathode of the QD-LED device, ZnO nanoparticles were spin coated to form a 60 nm layer. The ZnO nanoparticle layer serves as both the EIl, and ETL. Next, a solution of green-emitting CFQD® quantum dots [Nanoco Technologies Limited, Manchester, UK] comprising indium and phosphorus ($PL_{max}$ = 528 nm, FWHM = 39 nm) in toluene was spin coated onto the ZnO nanoparticle layer and heated to evaporate the toluene to form an ~ 15 nm QD emissive layer. Next, an HTL, having a thickness of 40 nm, made of 4,4'4" -tris(*N*-carbazolyl)triphenyl-amine (TCTA) is formed on the emissive layer via thermal evaporation. Then, an HIL, having a thickness of about 10 nm, made of molybdenum oxide is formed on the HTL via thermal evaporation.

Finally, an aluminum cathode layer, having a thickness of about 100 nm, is formed on the HIL via thermal evaporation.

*Reference Example 2*

Example 2 is the same as Example 1 except a TADF molecule (TADF-1; shown below; $PL_{max}$ = 548 nm, FWHM = 92 nm) was doped into the first 3 nm of the HTL adjacent to the emissive layer at a doping concentration of about 20 wt%. Therefore the first 3 nm of TCTA adjacent to the emissive layer had approximately 20 wt%. TADF while the remaining 37 nm not adjacent to the emissive layer was pure TCTA.

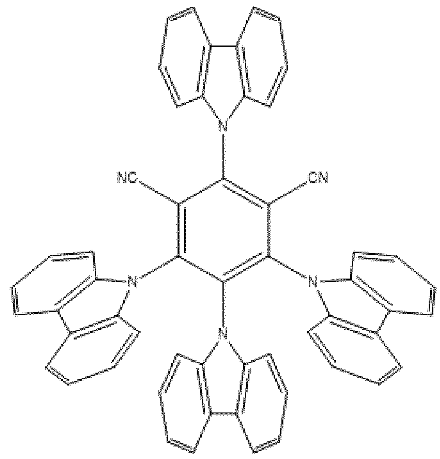

**TADF-1**

*Reference Example 3*

Example 3 is the same as Example 2 except the TADF-1 molecule was doped into the first 5 nm of the HTL adjacent to the emissive layer at a doping concentration of about 20 wt%. Therefore the first 5 nm of TCTA adjacent to the emissive layer had approximately 20 wt%. TADF while the remaining 35 nm not adjacent to the emissive layer was pure TCTA.

*Reference Example 4*

Example 4 is the same as Example 2 except the TADF-1 molecule was doped into the first 7 nm of the HTL adjacent to the emissive layer at a doping concentration of about 20 wt%. Therefore the first 7 nm of TCTA adjacent to the emissive layer had approximately 20 wt%. TADF while the remaining 33 nm not adjacent to the emissive layer was pure TCTA.

*Reference Example 5*

Example 5 is the same as Example 2 except the TADF-1 molecule was doped into the first 9 nm of the HTL adjacent to the emissive layer at a doping concentration of about 20 wt%. Therefore the first 9 nm of TCTA adjacent to the emissive layer had approximately 20 wt%. TADF while the remaining 31 nm not adjacent to the emissive layer was pure TCTA.

*Comparative Performance Data for Reference Examples 1-5*

FIG. 8 shows the maximum luminance ($cd/m^2$) values exhibited by the QD-LED devices of Examples 1-5. As shown, the QD-LED device which contained no TADF (Example 1) exhibited a maximum luminance of about 4200 $cd/m^2$. While the QD-LED devices of Examples 2-3, exhibited a lower or roughly equivalent maximum luminance as a QD-LED device with no TADF, a marked luminance enhancement is observed for the two thickest TADF-doped layers of 7 and 9 nm (Examples 4-5). This enhancement is about 125% for the 7 nm TADF-doped layer (Example 4) and about 170% for the 9 nm TADF-doped layer (Example 5) QD-LED devices at maximum brightness. This enhancement could be explained by overflow electrons being captured by the TADF recombining with holes and the subsequent energy transfer

from TADF to QDs. This is notable in that the largest enhancement comes from a TADF-doped layer thickness that is considerably thicker than the calculated critical distance (4.7 nm) beyond which the energy transfer efficiency is expected to decrease.

FIG. 9 shows the external quantum efficiencies (EQEs) exhibited by the QD-LED devices of Reference Examples 1-5. As can be seen, significant enhancement of the EQE and current efficiency is only observed in the 9 nm TADF-doped layer (Example 5) QD-LED device. Without being bound to any particular theory, the reason for this may be due to exciplex formation between the TADF molecule and the TCTA which is not the desirable transfer mechanism.

FIG. 10 shows emission spectra of the QD-LED devices of Reference Examples 1-5; "TCTA Ref' corresponds to Example 1 and "TADF PL" corresponds to pure TADF molecule. As can be seen, the pure TADF molecule exhibits a $PL_{max}$ = 548 nm and a FWHM = 92 nm. In all examples, other than pure TADF molecule, where green-emitting CFQD® quantum dots are present, the QD-LED devices exhibit a $PL_{max}$ = 538 nm and a FWHM = 42 nm. It is therefore clear that the triplet excitons are being harvested by the TADF molecule and transferred to the QDs for delayed fluorescence and such delayed fluorescence originates from the QD-containing emissive layer.

*Reference Example 6*

It has been shown that TADF molecules and TCTA can form an exciplex excited state and so the photoluminescence quantum yield (PLQY) of such films can be diminished. The host material 3,3-di(9H-carbazol-9-yl)biphenyl (mCBP) has been used in TADF devices with great success, maintaining PLQY for films in the region of 90 %. As such, another example device is presented whereby an mCBP HTL buffer is placed between the quantum dot emissive layer and the TCTA HTL.

In this example another exemplary electroluminescent QD-LED device was constructed according to the energy level diagram of FIG. 11. Onto an indium tin oxide (ITO) substrate, which serves as the cathode of the QD-LED device, ZnO nanoparticles were spin coated to form a 60 nm layer. The ZnO nanoparticle layer serves as both the EIl, and ETL. Next, a solution of green-emitting CFQD® quantum dots ($PL_{max}$ = 529 nm, FWHM = 39 nm) in toluene was spin coated onto the ZnO nanoparticle layer and heated to evaporate the toluene to form an ~15 nm QD emissive layer. Next an HTL buffer, having a thickness of about 8 nm, made of 3,3-di(9H-carbazol-9-yl)biphenyl (mCBP) is formed on the emissive layer via thermal evaporation. Then, an HTL, having a thickness of 40 nm, made of 4,4'4"-tris(A-carbazolyl)triphenylamine (TCTA) is formed on the HTL buffer via thermal evaporation. Then, an HIL, having a thickness of about 10 nm, made of molybdenum oxide is formed on the HTL via thermal evaporation. Finally, an aluminum cathode layer, having a thickness of about 100 nm, is formed on the HIL via thermal evaporation.

*Reference Example 7*

Example 7 is the same as Example 6 except the TADF-1 molecule was doped into about the first 2 nm of the HTL buffer adjacent to the emissive layer at a doping concentration of about 20 wt%. Therefore the first 2 nm of the HTL buffer adjacent to the emissive layer had approximately 20 wt%. TADF while the remaining 6 nm not adjacent to the emissive layer was pure mCBP.

*Reference Example 8*

Example 8 is the same as Example 7 except the TADF-1 molecule was doped into about the first 4 nm of the HTL buffer adjacent to the emissive layer at a doping concentration of about 20 wt%. Therefore the first 4 nm of the HTL buffer adjacent to the emissive layer had approximately 20 wt%. TADF while the remaining 4 nm not adjacent to the emissive layer was pure mCBP.

*Reference Example 9*

Example 9 is the same as Example 7 except the TADF-1 molecule was doped into about the first 6 nm of the HTL buffer adjacent to the emissive layer at a doping concentration of about 20 wt%. Therefore the first 6 nm of the HTL buffer adjacent to the emissive layer had approximately 20 wt%. TADF while the remaining 2 nm not adjacent to the emissive layer was pure mCBP.

*Reference Example 10*

Example 10 is the same as Example 7 except the TADF-1 molecule was doped into the entire HTL buffer layer adjacent to the emissive layer at a doping concentration of about 20 wt%.

*Reference Example 11*

In this example an electroluminescent QD-LED device was constructed according to the energy level diagram of FIG. 11. Onto an indium tin oxide (ITO) substrate, which serves as the cathode of the QD-LED device, ZnO nanoparticles was spin coated to form a 60 nm layer. The ZnO nanoparticle layer serves as both the EII, and ETL. Next a solution of green-emitting QDs InP ($PL_{max}$ = 528 nm, FWHM = 39 nm) in toluene was spin coated onto the ZnO nanoparticle layer and heated to evaporate the toluene to form an ~15 nm QD emissive layer. Next, an HTL, having a thickness of 40 nm, made of 4,4'4"-tris(A-carbazolyl)triphenyl-amine (TCTA) is formed on the emissive layer via thermal evaporation. Then, an HIL, having a thickness of about 10 nm, made of molybdenum oxide is formed on the HTL via thermal evaporation. Finally, an aluminum cathode layer, having a thickness of about 100 nm, is formed on the HIL via thermal evaporation. Example 11 is the same as examples 6-10 except the QD-LED device does not contain the mCBP HTL buffer or TADF molecule; it is a QD-containing QD-LED device only.

*Comparative Performance Data for Reference Examples 6-11*

FIG. 12 shows the maximum luminance ($cd/m^2$) values exhibited by the QD-LED devices of Examples 6-11. As shown, the QD-LED device which contained no TADF (Example 6) exhibited a maximum luminance of about 3800 $cd/m^2$. The QD-LED device which contained no TADF and no mCBP (Example 11, labeled as "Ref') exhibited a maximum luminance of about 4200 $cd/m^2$. A marginal luminance enhancement is observed for the TADF-doped mCBP layer of 2 nm (Example 7). A marked luminance enhancement is observed for the TADF-doped mCBP layers of 4, 6 and 8 nm (Examples 8-10). Specifically, the enhancement is about 145% for the 4 nm TADF-doped mCBP layer (Example 8), about 225% for the 6 nm TADF-doped mCBP layer (Example 9), and about 230% for the 8 nm TADF-doped mCBP layer (Example 9) QD-LED devices at maximum brightness. This enhancement could be explained by overflow electrons being captured by the TADF recombining with holes and the subsequent energy transfer from TADF to QDs. This is notable in that the largest enhancement comes from a TADF-doped layer thickness that is considerably thicker than the calculated critical distance (4.7 nm) beyond which the energy transfer efficiency is expected to decrease.

FIG. 13 shows the external quantum efficiencies (EQEs) exhibited by the QD-LED devices of Reference Examples 6-11; Example 11 is labeled as "Ref." As can be seen, significant enhancement of the EQE and current efficiency is only observed in the 4, 6, and 8 nm TADF-doped mCBP layer (Examples 8-10) QD-LED devices.

FIG. 14 shows emission spectra of the QD-LED devices of Reference Examples 6-11; "TCTA Ref' corresponds to Example 1, "mCBP Ref' corresponds to Example 6 and "TADF PL" corresponds to pure TADF molecule. As can be seen, the pure TADF molecule exhibits a $PL_{max}$ = 548 nm and a FWHM = 92 nm. In all examples, other than pure TADF molecule, where green-emitting CFQD® quantum dots are present, the QD-LED devices exhibit a $PL_{max}$ = 538 nm and a FWHM = 42 nm. It is therefore clear that the triplet excitons are being harvested by the TADF molecule and transferred to the QDs for delayed fluorescence and such delayed fluorescence originates from the QD-containing emissive layer.

*Example 12 (accordin to the presently claimed invention)*

In this example, an emissive film comprising TADF molecules and QDs was prepared. A solution of green-emitting CFQD® quantum dots [Nanoco Technologies Limited, Manchester, UK] comprising indium and phosphorus ($PL_{max}$ = 527 nm, FWHM = 40 nm) in toluene was prepared at a concentration of 2 mg/mL. A solution of sky blue-emitting TADF molecules ( TADF-2 (shown below; $PL_{max}$ = 486 nm, FWHM = 81 nm when deposited as a film) in toluene was prepared at a concentration of 10 mg/mL.

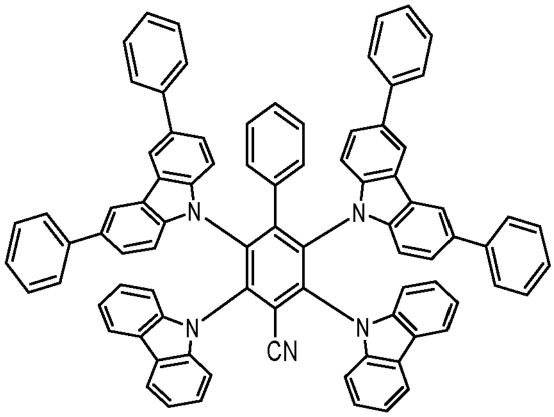

**TADF-2**

0.25 mL of the TADF solution and 5 mL of the QD solution were combined and spin-coated onto a quartz glass substrate at a rate of 2,000 rpm for 60 seconds to form a 20 nm film.

The PL spectrum and transient PL characteristics were measured. As can be seen in FIG. 15, the PL spectrum shows a single emission peak ($PL_{max}$ ~ 535 nm, FWHM ~ 39 nm), indicative of energy transfer from the TADF molecules to the QDs. FIG. 16 shows the PL intensity *versus* time. The transient PL characteristics were used to calculate a transient lifetime, with a prompt component, $\tau_1$, = 0.124 $\mu$s and a delayed component, $\tau_2$, = 1.356 $\mu$s. For comparison, the transient lifetime of a QD-only film at the same concentration was $\tau_1$ = 0.02 $\mu$s and $\tau_2$ = 0.14 $\mu$s. The longer lifetime of the delayed component from the combined TADF-QD film compared to the QD-only film may be further indicative of energy transfer from the TADF molecules to the QDs. Overall, the results demonstrate the compatibility of TADF molecules and QDs in a combined film, resulting in an energy transfer process from the TADF molecules to the QDs.

*Reference Example 13*

In this example, an exemplary electroluminescent QD-LED device was constructed according to the energy level diagram of FIG. 17. Onto an indium tin oxide (ITO) substrate, which serves as the cathode of the QD-LED device, Mg-doped ZnO nanoparticles having a stoichiometry of about $Zn_{0.9}Mg_{0.1}O$ were spin coated to form an 80 nm layer. The Mg-doped ZnO nanoparticle layer serves as both the EIL and ETL. Next, a solution of green-emitting CFQD® quantum dots [Nanoco Technologies Limited, Manchester, UK] comprising indium and phosphorus ($PL_{max}$ = 525 nm, FWHM = 40 nm) in toluene was spin coated onto the Mg-doped ZnO nanoparticle layer and heated to evaporate the toluene to form an ~ 10 nm QD emissive layer. Subsequently, a layer of mCBP HTL buffer layer, having a thickness of about 6 nm, was formed on the emissive layer via thermal evaporation. Next, a dual HTL comprising a 13 nm layer of TCTA and a 30 nm layer of 1,2-bis[(di-4-tolylamino)phenyl]cyclohexane (TAPC) was formed on the emissive layer via thermal evaporation. Then, an HIL, having a thickness of about 10 nm, made of molybdenum oxide was formed on the HTL via thermal evaporation. Finally, an aluminum cathode layer, having a thickness of about 100 nm, was formed on the HIL via thermal evaporation.

*Reference Example 14*

Example 14 is the same as Example 13 except that the QD layer thickness was increased to 15 nm and a TADF molecule (TADF-2; $PL_{max}$ = 486 nm, FWHM = 81 nm) was doped into the mCPB HTL buffer layer adjacent to the emissive layer at a doping concentration of about 30 wt%.

*Reference Example 15*

Example 15 is the same as Example 14, except that the QD layer thickness was reduced to 10 nm.

*Reference Example 16*

Example 16 is the same as Example 14, except that the TADF molecule was doped into the mCPB HTL buffer layer adjacent to the emissive layer at a doping concentration of about 40 wt%.

*Reference Example 17*

Example 17 was the same as Example 16, except that the QD layer thickness was reduced to 10 nm.

*Comparative Performance Data for Reference Examples 13-17*

The optical properties of the devices prepared in Reference Examples 13 - 17 are summarized in Table 2 and illustrated in FIGS. 18 and 19. In general, the Examples 13-17 differ from the previous examples 1-12 in that 1) they utilize a Mg-doped ZnO nanoparticle layer as the EIl, and ETL rather than a pure ZnO nanoparticle layer; 2) they utilize a higher amount of TADF in the mCBP layer (30-40 wt. % TADF); and 3) they utilize a dual HTL of TCTA/TAPC rather than a single HTL of TCTA which improves charge balance. The highest EQE of 14.73 % was seen at a TADF doping level of 40 %, with a QD layer thickness of 10 nm (Example 17). The EL spectrum from Example 15, compared to the PL spectrum of the TADF molecule and the EL spectrum of the QDs, is shown in FIG. 20. As can be seen, the emission of the device comprising QDs and TADF molecules is entirely from the QD layer.

Table 2.

| Example | QD Layer Thickness (nm) | mCBP:TADF (wt. % of TADF) | Max. Luminance ($cd/m^2$) | EQE at 500 $cd/m^2$ (%) | EQE at 1,000 $cd/m^2$ (%) |
|---|---|---|---|---|---|
| 13 (Control - QD only) | 10 | 0 (no TADF) | 4,265 | 6.52 | 6.24 |
| 14 | 15 | 30 | 6,317 | 13.32 | 12.23 |
| 15 | 10 | 30 | 6,792 | 8.57 | 8.12 |
| 16 | 15 | 40 | 4,750 | 9.75 | 8.85 |
| 17 | 10 | 40 | 6,220 | 14.73 | 13.55 |

**Multi-Element Displays**

In accordance with various aspects of the present disclosure, electroluminescent (EL) devices comprising QDs and TADF molecules, as described herein, may be used to create a multi-element display device. For example, a display panel may comprise red, green and blue (RGB) pixels. One, two, or all three of the RGB pixels may comprise an electroluminescent device comprising QDs and TADF molecules. Where only one or two of the RGB pixels comprise an electroluminescent device comprising QDs and TADF molecules, the remaining pixel(s) may comprise one or more of the following: a QD-EL device (i.e., an EL device comprising QDs but no TADF molecules), a TADF-EL device (i.e., an EL device comprising TADF molecules but no QDs), a TADF hyperfluorescent device (i.e., a device where TADF molecules are used in conjunction with another type of emissive material such as, for example, an organic molecule, to achieve hyperflourescence), or an OLED device (i.e., an organic light emitting diode with neither QDs nor TADF molecules). For example, a blue pixel comprising QDs and TADF molecules may be used in combination with a green QD-EL pixel and a red OLED pixel. Also for example, a blue pixel comprising QDs and TADF molecules may be used in combination with a green QD-EL pixel and a pixel having red-emitting QDs and TADF molecules. These devices can have none, one or multiples of charge transport layers in common. For example, the ETL may be common across the subpixel or, alternatively, the p-type hole transport layers may be in common.

## Claims

**1.** An emissive layer for an electroluminescent display device, the emissive layer comprising:
a two-dopant system, the two-dopant system comprising:

a population of quantum dots (QDs); and
a population of molecules exhibiting thermally activated delayed fluorescence (TADF), wherein the TADF molecules are selected from:

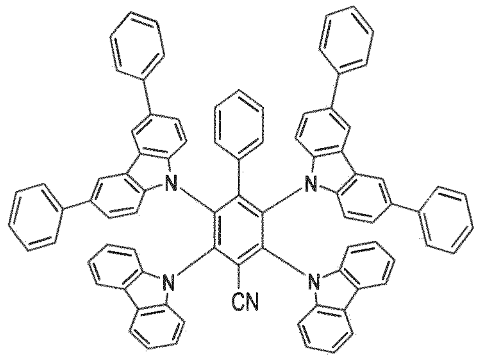

,

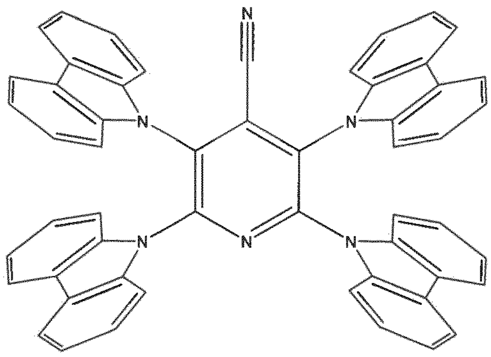

(2,3,5,6-tetra(9H-carbazol-9-yl)isonicotinonitrile,

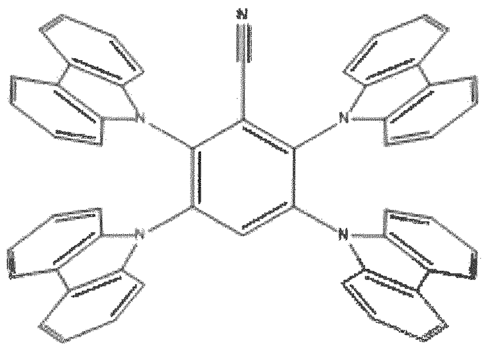

(2,3,5,6-tetra(9H-carbazol-9-yl)benzonitrile),

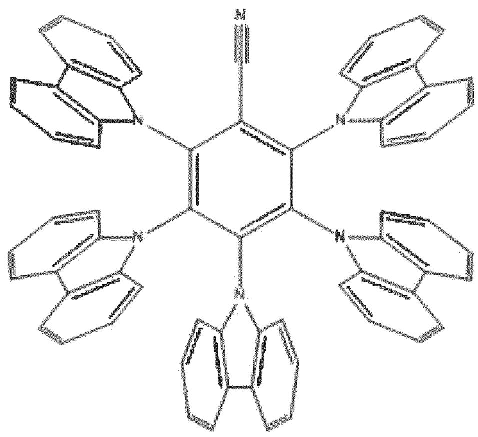

(2,3,4,5,6-penta(9H-carbazol-9-yl)benzonitrile),

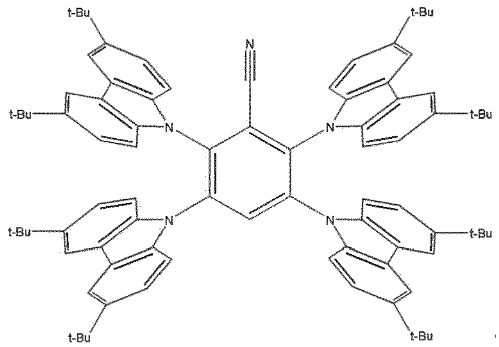

(2,3,5,6-tetrakis(3,6-di-tert-butyl-9H-carbazol-9-yl)benzonitrile), and

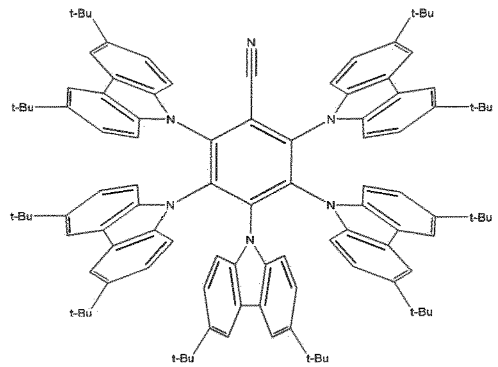

(2,3,4,5,6-pentakis(3,6-di-tert-butyl-9H-carbazol-9-yl)benzonitrile); and
wherein:

the emissive layer is free of host matrix; and
the emissive layer has a QD:TADF molecule ratio of 6: 1 to 1 : 1 by weight.

**2.** The emissive layer of claim 1, wherein the QDs are fluorescent emitters.

**3.** The emissive layer of claim 1 or claim 2, wherein a spectral overlap exists between the TADF emission and the QD absorption.

**4.** The emissive layer of any one of claims 1 to 3, wherein the emissive layer is an emissive film.

**5.** The emissive layer of claim 1:

(i) wherein the TADF molecules are emissive donor-assistant dopants; or
(ii) wherein the emissive layer has a QD:TADF molecule ratio of 4.5:1 to 3.5:1 by weight.

**6.** The emissive layer of claim 1:

(i) wherein the population of QDs comprises one or more of red-emitting QDs, green-emitting QDs, and blue-emitting QDs; or
(ii) wherein the physical distance between a QD and TADF molecule is dependent upon the length of a capping ligand bound to a surface of the QD.

## Patentansprüche

1. Emissionsschicht für eine elektrolumineszente Anzeigevorrichtung, wobei die Emissionsschicht Folgendes umfasst: ein Zwei-Dotanden-System, wobei das Zwei-Dotanden-System Folgendes umfasst:

   eine Population von Quantenpunkten (QDs); und
   eine Population von Molekülen, welche eine thermisch aktivierte verzögerte Fluoreszenz (TADF) aufzeigen, wobei die TADF-Moleküle ausgewählt sind aus Folgendem:

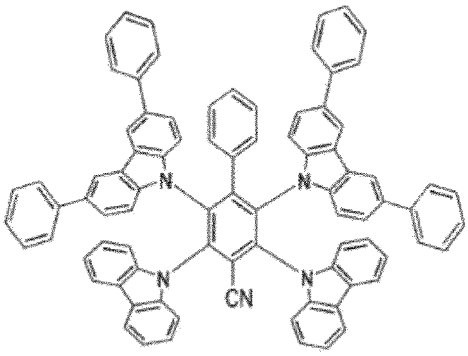

,

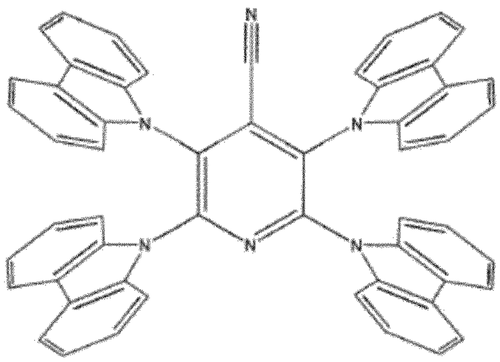

(2,3,5,6-Tetra(9H-carbazol-9-yl)isonicotinonitril,

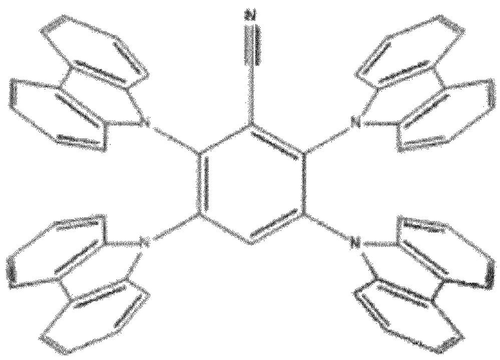

(2,3,5,6-Tetra(9H-carbazol-9-yl)benzonitril),

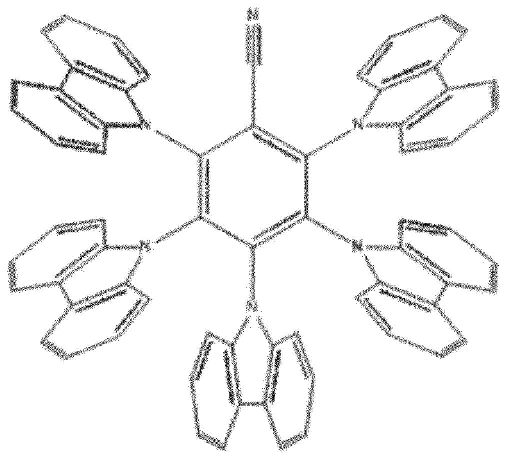

(2,3,4,5,6-Penta(9H-carbazol-9-yl)benzonitril),

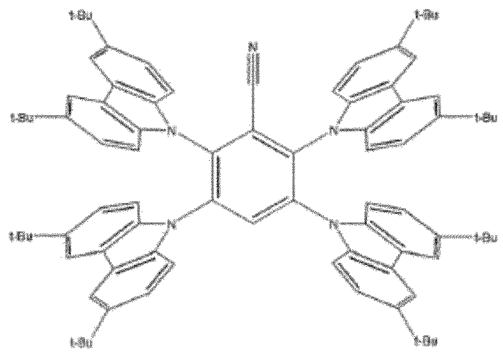

(2,3,5,6-Tetrakis(3,6-di-tert-butyl-9H-carbazol-9-yl)benzonitril), und

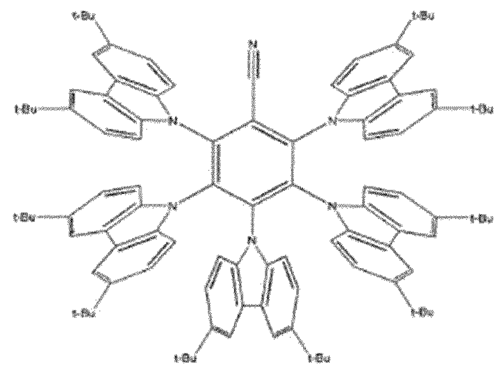

(2,3,4,5,6-Pentakis(3,6-di-tert-butyl-9H-carbazol-9-yl)benzonitril); und
wobei:

die Emissionsschicht frei von Wirtsmatrix ist; und
die Emissionsschicht ein QD:TADF-Molekül-Verhältnis von 6:1 bis 1:1 nach Gewicht aufweist.

**2.** Emissionsschicht nach Anspruch 1, wobei die QDs fluoreszierende Emitter sind.

**3.** Emissionsschicht nach Anspruch 1 oder Anspruch 2, wobei eine spektrale Überlappung zwischen der TADF-Emission und der QD-Absorption vorhanden ist.

**4.** Emissionsschicht nach einem der Ansprüche 1 bis 3, wobei die Emissionsschicht ein Emissionsfilm ist.

**5.** Emissionsschicht nach Anspruch 1:

(i) wobei die TADF-Moleküle Emissions-Donor-Hilfs-Dotanden sind; oder
(ii) wobei die Emissionsschicht ein QD:TADF-Molekül-Verhältnis von 4,5:1 bis 3,5:1 nach Gewicht aufweist.

**6.** Emissionsschicht nach Anspruch 1:

(i) wobei die Population von QDs einen oder mehrere Rot emittierende QDs, Grün emittierende QDs und Blau emittierende QDs aufweist; oder
(ii) wobei der physische Abstand zwischen einem QD und einem TADF-Molekül von der Länge eines an eine Fläche des QD gebundenen Capping-Liganden abhängt.

**Revendications**

**1.** Couche émissive pour un dispositif d'affichage électroluminescent, la couche émissive comprenant :
un système à deux dopants, le système à deux dopants comprenant :

une population de points quantiques (QD) ; et
une population de molécules présentant une fluorescence retardée thermiquement activée (TADF), où les molécules TADF sont choisies parmi :

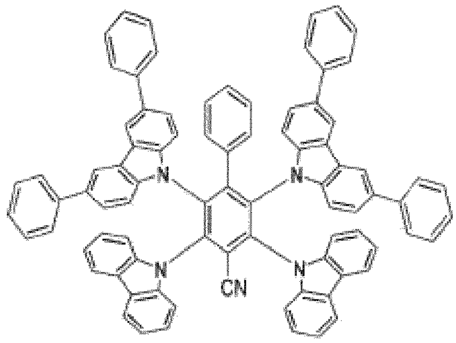

,

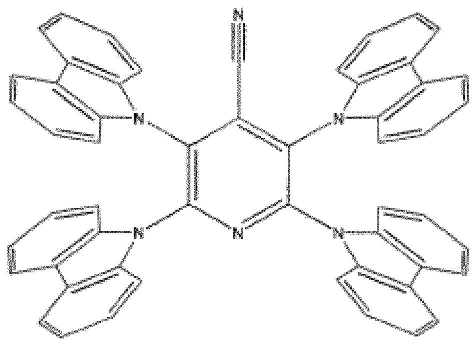

(2,3,5,6-tétra(9H-carbazol-9-yl)isonicotinonitrile),

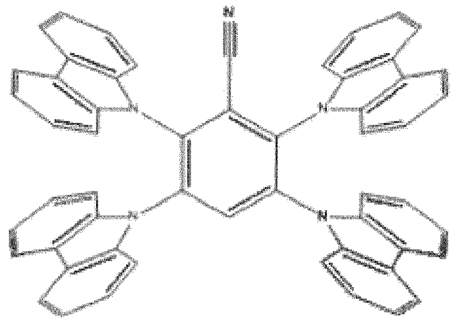

(2,3,5,6-tétra(9H-carbazol-9-yl)benzonitrile),

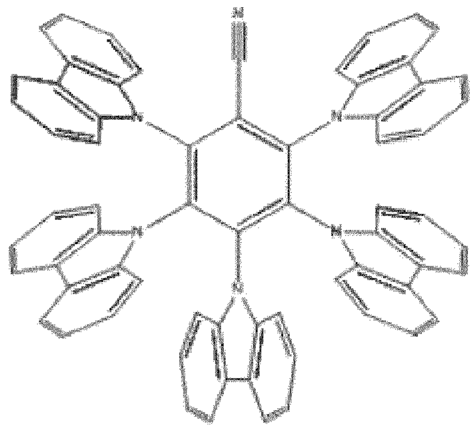

(2,3,4,5,6-penta(9H-carbazol-9-yl)benzonitrile),

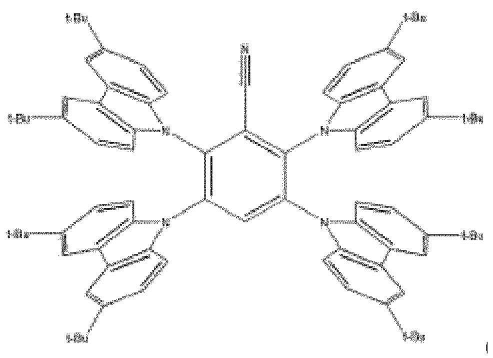

(2,3,5,6-tétraki s(3,6-di-tert-butyl-9H-carbazol-9-yl)benzonitrile), et

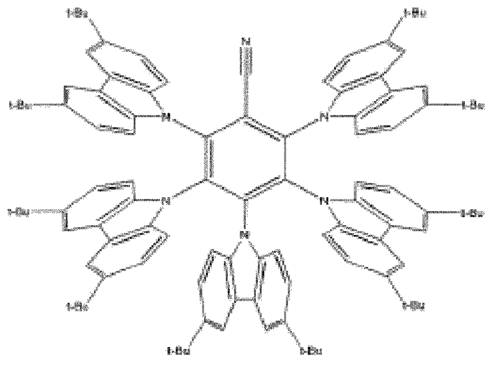

(2,3,4,5,6-pentakis(3,6-di-tert-butyl-9H-carbazol-9-yl)benzonitrile) ; et
dans laquelle :

la couche émissive est dépourvue de matrice hôte ; et
la couche émissive a un rapport en poids QD:molécule TADF de 6:1 à 1:1.

**2.** Couche émissive selon la revendication 1, dans laquelle les QD sont des émetteurs fluorescents.

**3.** Couche émissive selon la revendication 1 ou la revendication 2, dans laquelle un chevauchement spectral existe entre l'émission TADF et l'absorption QD.

**4.** Couche émissive selon l'une quelconque des revendications 1 à 3, dans laquelle la couche émissive est un film émissif.

**5.** Couche émissive selon la revendication 1 :

(i) dans laquelle les molécules TADF sont des dopants assistants donneurs émissifs ; ou
(ii) dans laquelle la couche émissive a un rapport en poids QD:molécule TADF de 4,5:1 à 3,5:1.

**6.** Couche émissive selon la revendication 1 :

(i) dans laquelle la population de QD comprend un ou plusieurs QD à émission rouge, QD à émission verte et QD à émission bleue ; ou
(ii) dans laquelle la distance physique entre un QD et une molécule TADF dépend de la longueur d'un ligand de coiffage lié à une surface du QD.

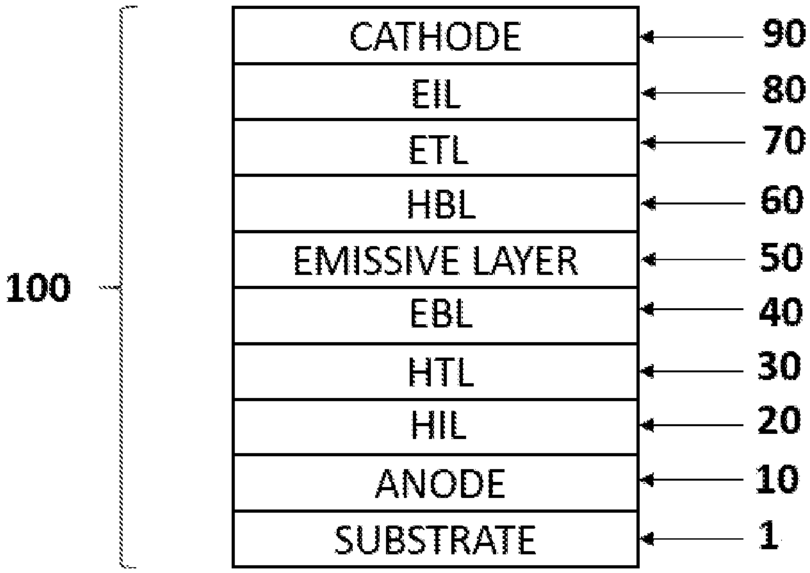
CATHODE
EIL
ETL
HBL
EMISSIVE LAYER
EBL
HTL
HIL
ANODE
SUBSTRATE
90
80
70
60
50
40
30
20
10
1
100

FIG. 1

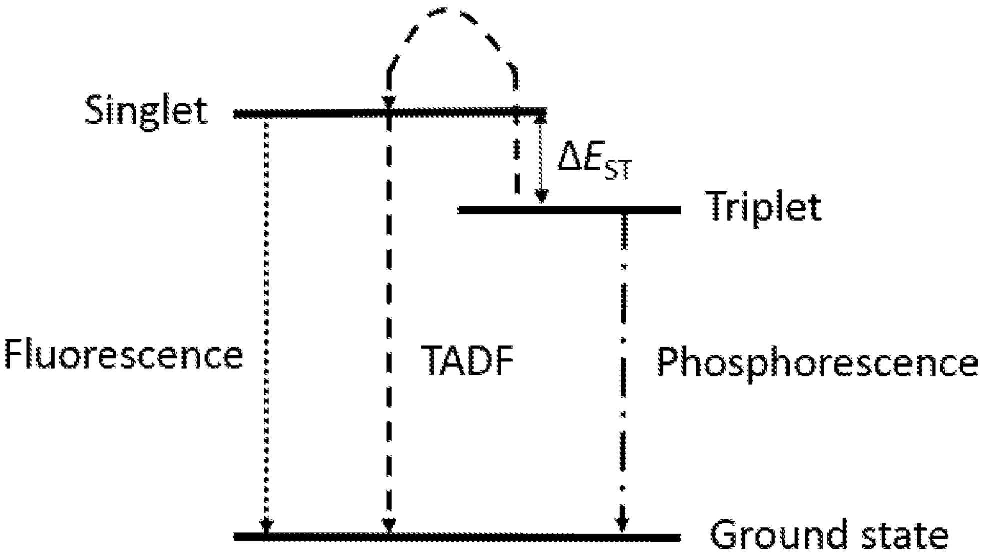
Singlet
ΔE_ST
Triplet
Fluorescence
TADF
Phosphorescence
Ground state

FIG. 2

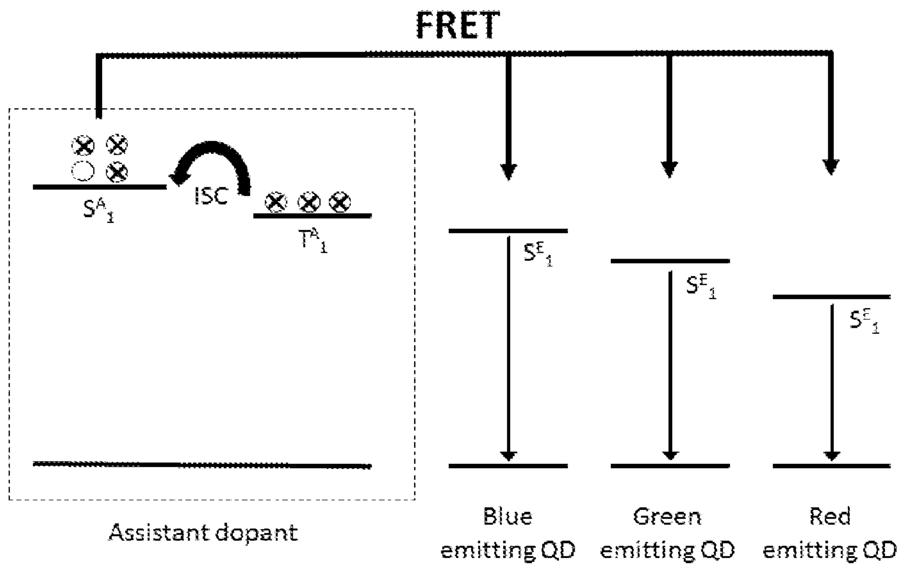
FRET
ISC
Assistant dopant
Blue emitting QD
Green emitting QD
Red emitting QD

FIG. 3

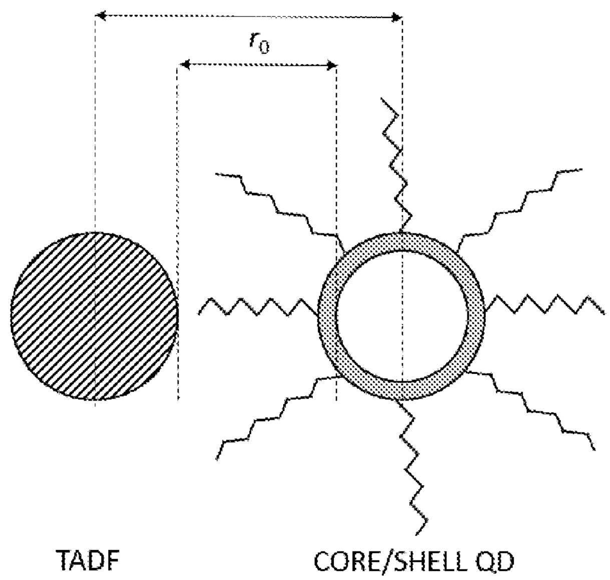
TADF
CORE/SHELL QD

FIG. 4

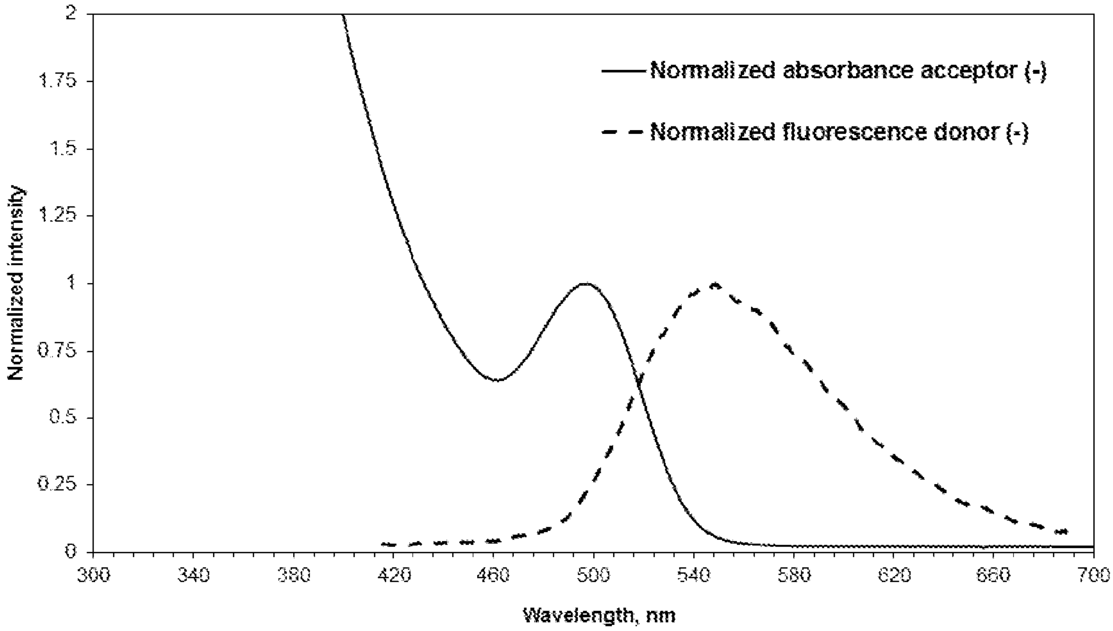
Normalized absorbance acceptor (-)
Normalized fluorescence donor (-)
Normalized intensity
Wavelength, nm
2
1.75
1.5
1.25
1
0.75
0.5
0.25
0
300
340
380
420
460
500
540
580
620
660
700

FIG. 5

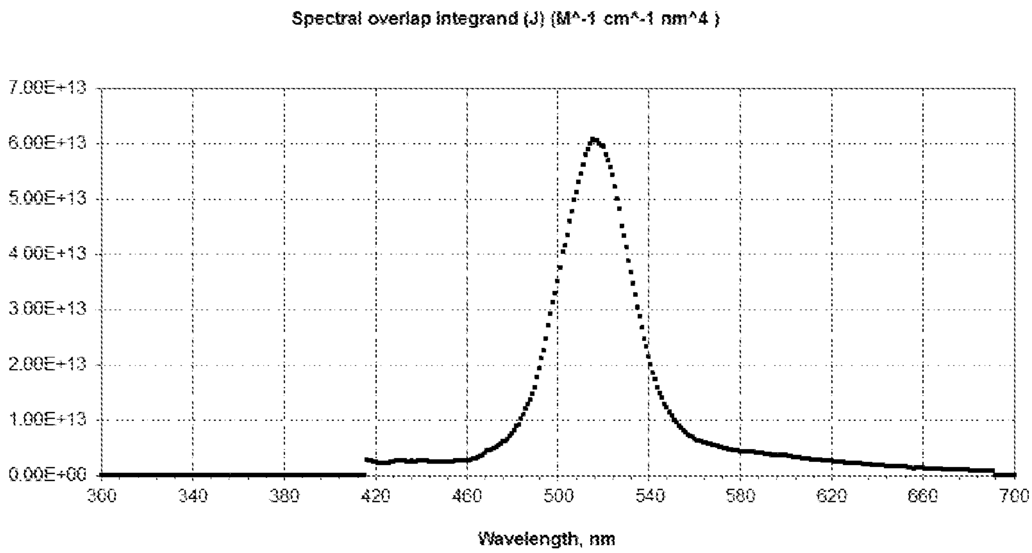
Spectral overlap integrand (J) (M^-1 cm^-1 nm^4 )
7.00E+13
6.00E+13
5.00E+13
4.00E+13
3.00E+13
2.00E+13
1.00E+13
0.00E+00
300
340
380
420
460
500
540
580
620
660
700
Wavelength, nm

FIG. 6

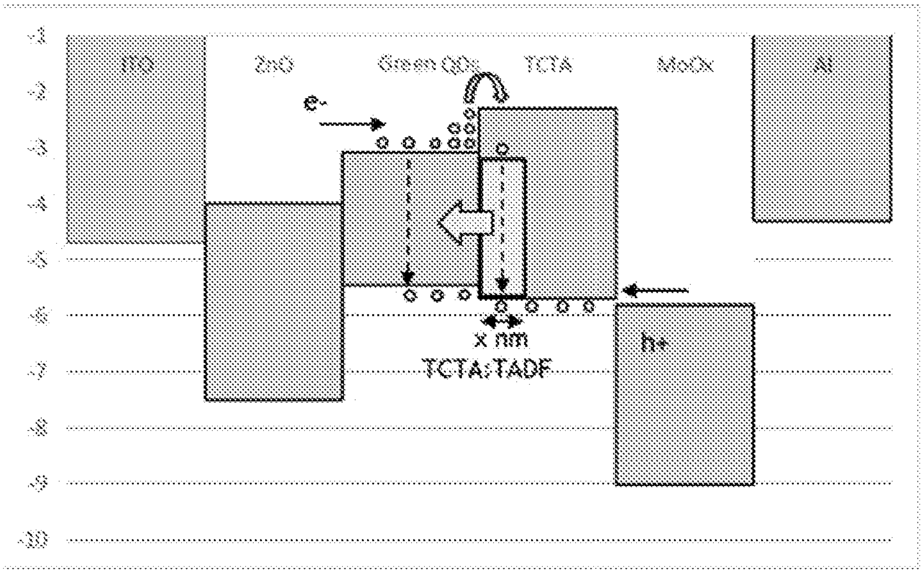
ITO
ZnO
Green QDs
TCTA
MoOx
Al
e-
h+
x nm
TCTA:TADF

FIG. 7

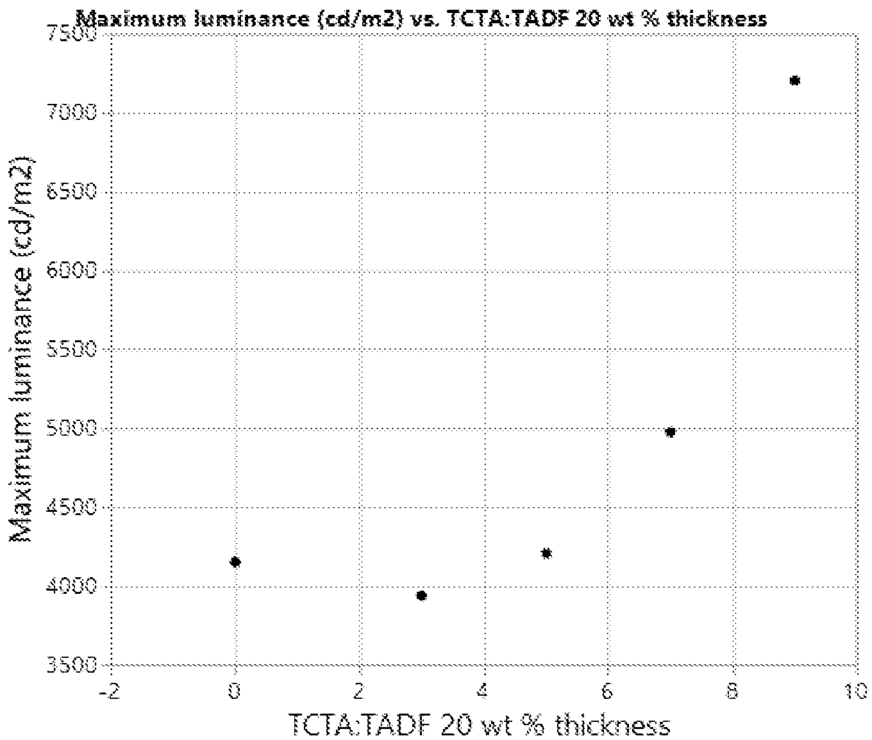
Maximum luminance (cd/m2) vs. TCTA:TADF 20 wt % thickness
Maximum luminance (cd/m2)
TCTA:TADF 20 wt % thickness
7500
7000
6500
6000
5500
5000
4500
4000
3500
-2
0
2
4
6
8
10

FIG. 8

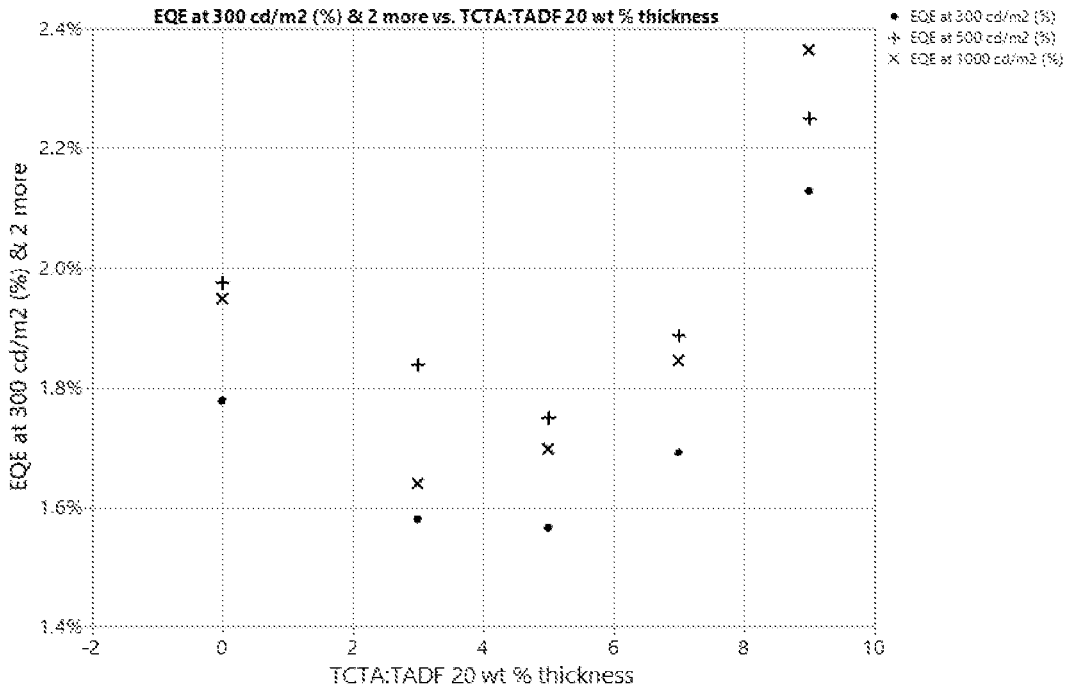
EQE at 300 cd/m2 (%) & 2 more vs. TCTA:TADF 20 wt % thickness
EQE at 300 cd/m2 (%)
EQE at 500 cd/m2 (%)
EQE at 1000 cd/m2 (%)
EQE at 300 cd/m2 (%) & 2 more
2.4%
2.2%
2.0%
1.8%
1.6%
1.4%
-2
0
2
4
6
8
10
TCTA:TADF 20 wt % thickness

FIG. 9

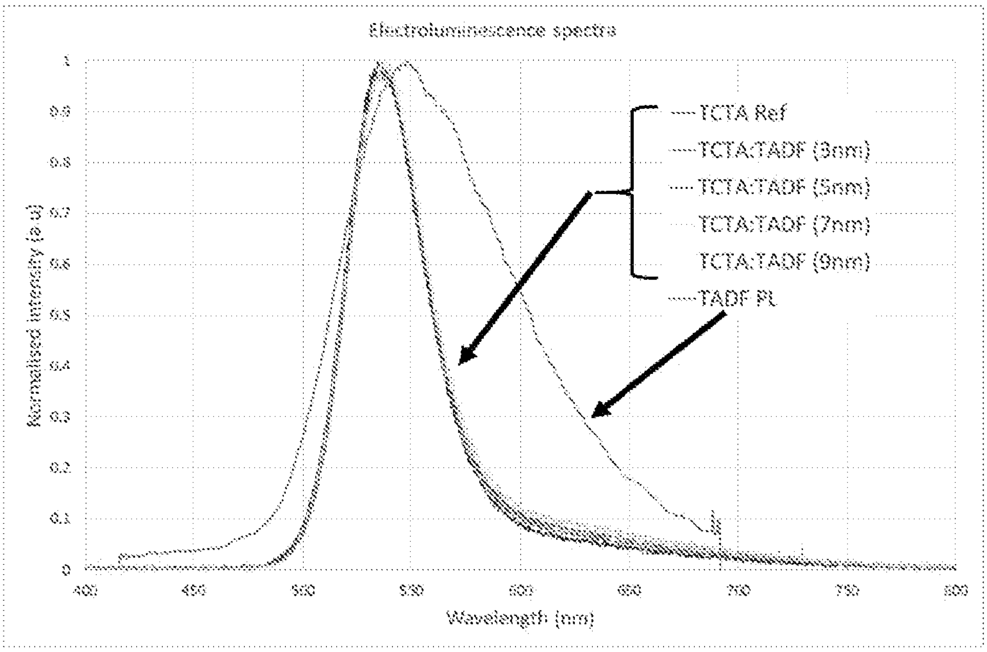
Electroluminescence spectra
TCTA Ref
TCTA:TADF (3nm)
TCTA:TADF (5nm)
TCTA:TADF (7nm)
TCTA:TADF (9nm)
TADF PL
Normalised intensity (a.u)
Wavelength (nm)

FIG. 10

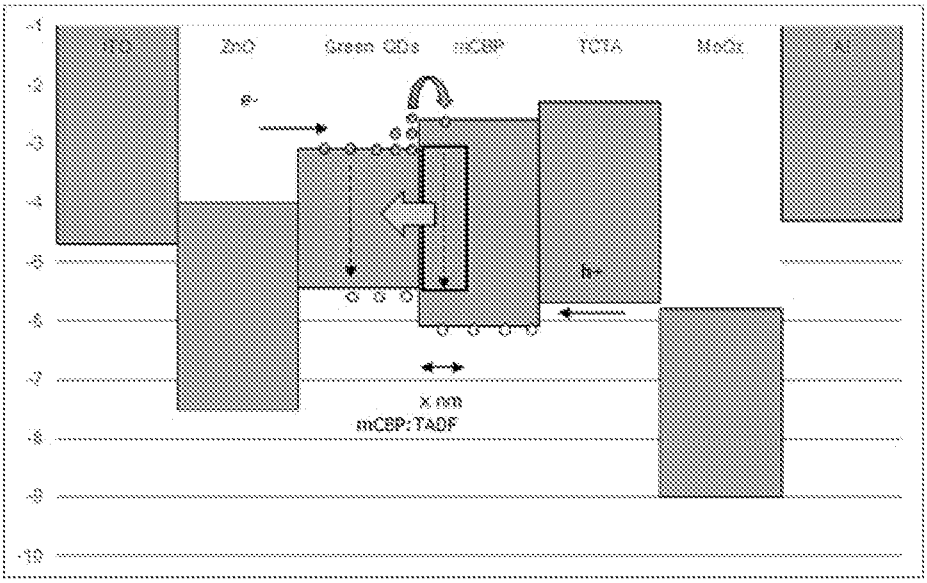
ZnO
Green QDs
mCBP
TCTA
MoOx
e-
h+
x nm
mCBP:TADF

FIG. 11

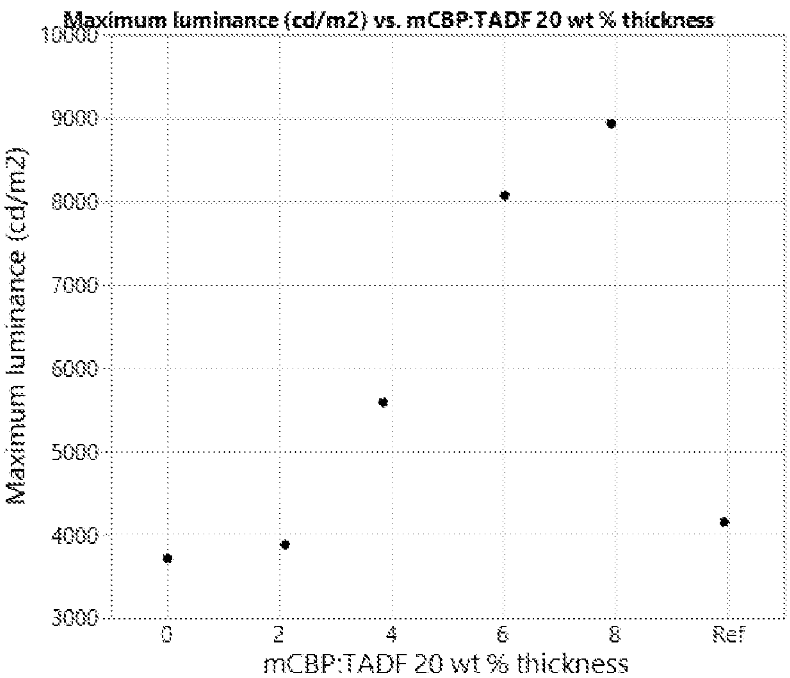
Maximum luminance (cd/m2) vs. mCBP:TADF 20 wt % thickness
Maximum luminance (cd/m2)
10000
9000
8000
7000
6000
5000
4000
3000
0
2
4
6
8
Ref
mCBP:TADF 20 wt % thickness

FIG. 12

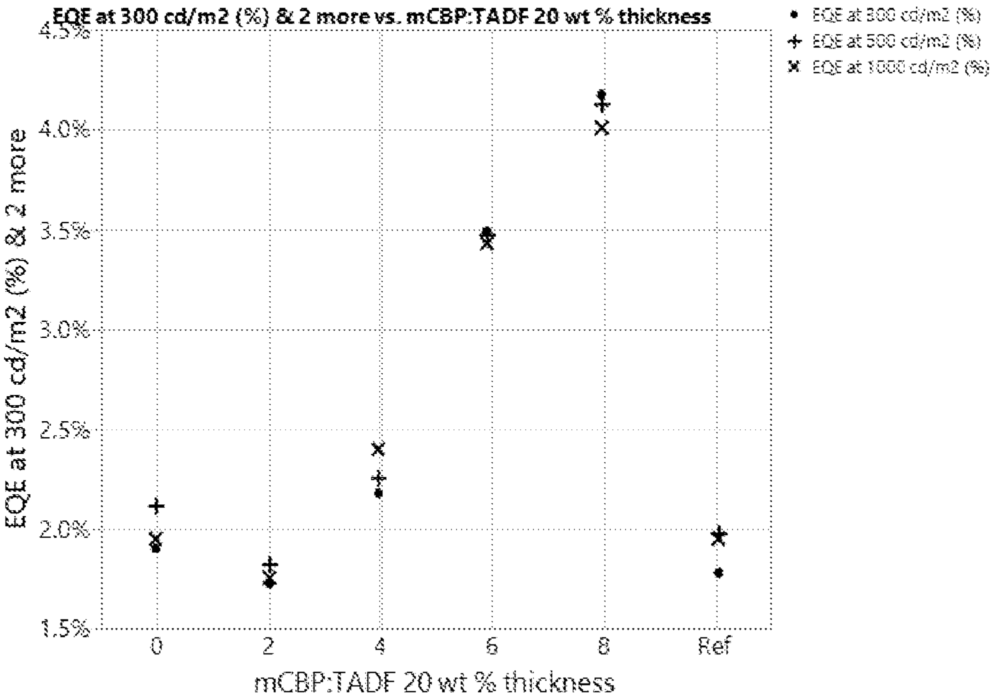
EQE at 300 cd/m2 (%) & 2 more vs. mCBP:TADF 20 wt % thickness
EQE at 300 cd/m2 (%)
EQE at 500 cd/m2 (%)
EQE at 1000 cd/m2 (%)
EQE at 300 cd/m2 (%) & 2 more
4.5%
4.0%
3.5%
3.0%
2.5%
2.0%
1.5%
0
2
4
6
8
Ref
mCBP:TADF 20 wt % thickness

FIG. 13

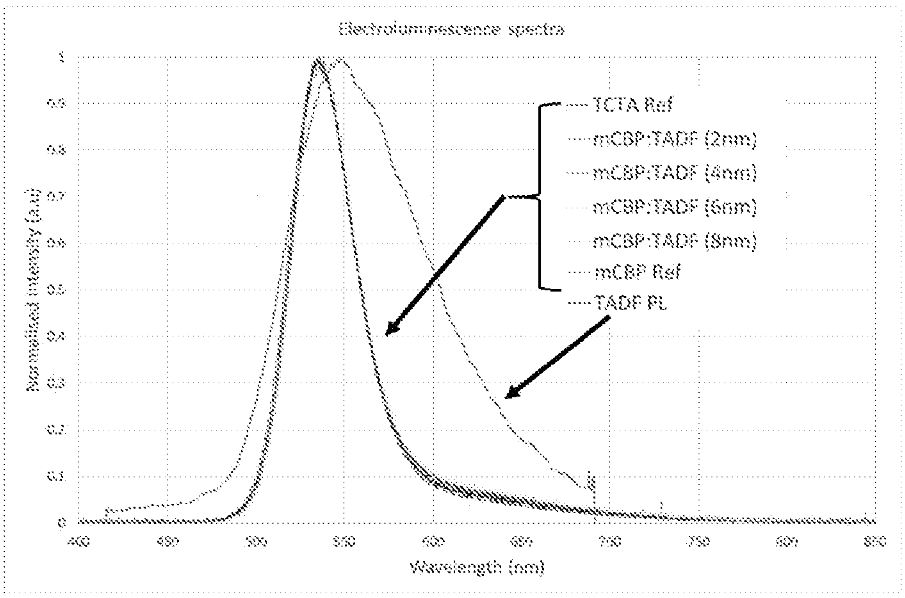
Electroluminescence spectra
TCTA Ref
mCBP:TADF (2nm)
mCBP:TADF (4nm)
mCBP:TADF (6nm)
mCBP:TADF (8nm)
mCBP Ref
TADF PL
Normalised intensity (a.u.)
Wavelength (nm)

FIG. 14

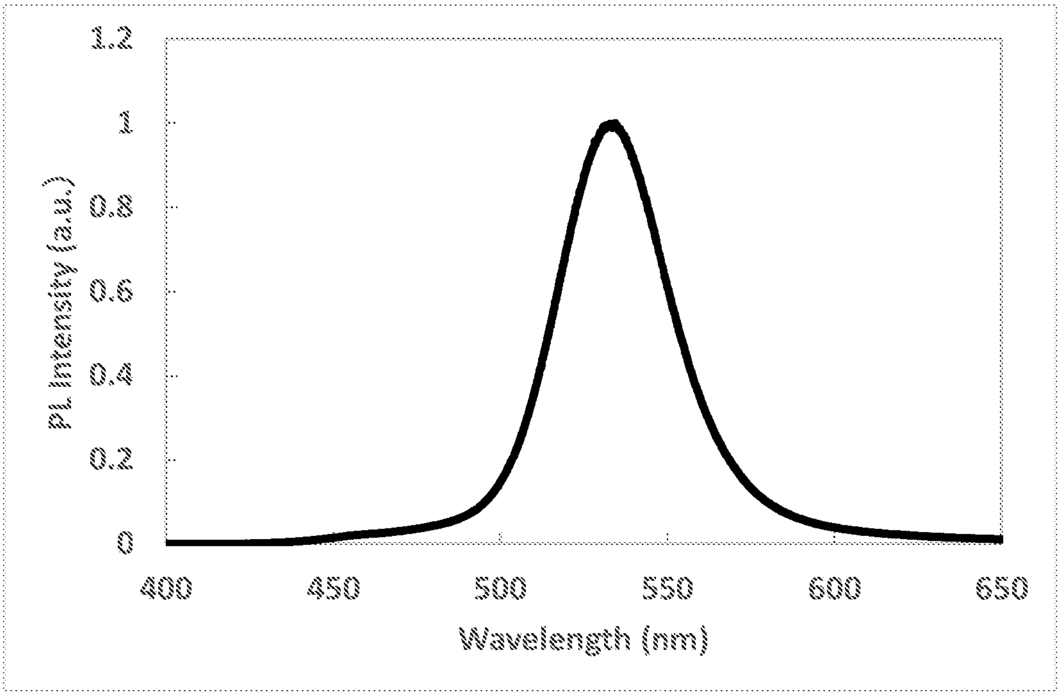
1.2
1
0.8
0.6
0.4
0.2
0
400
450
500
550
600
650
Wavelength (nm)
PL Intensity (a.u.)

FIG. 15

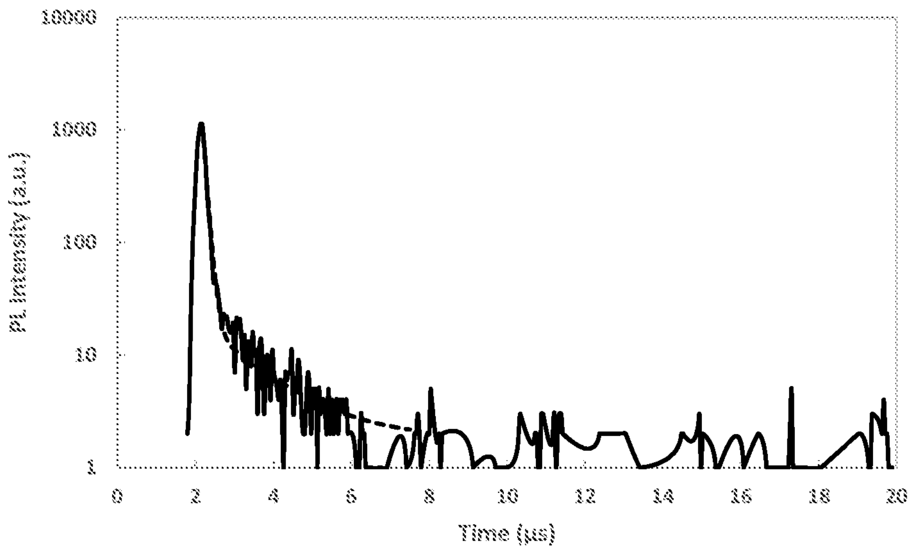
10000
1000
100
10
1
0
2
4
6
8
10
12
14
16
18
20
Time (μs)
PL Intensity (a.u.)

FIG. 16

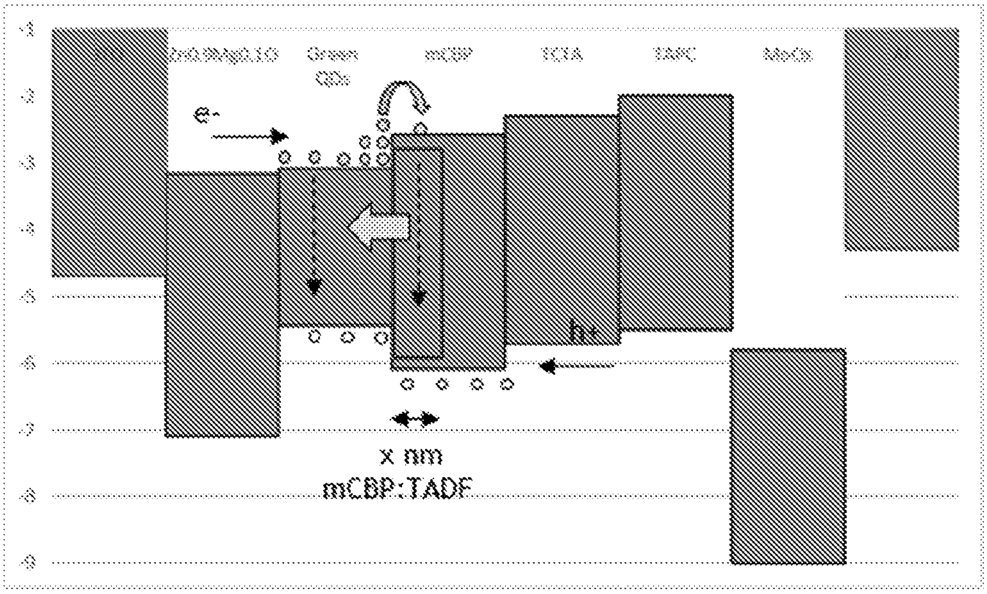
Green QDs
mCBP
TCTA
TAPC
e-
h+
x nm
mCBP:TADF

**FIG. 17**

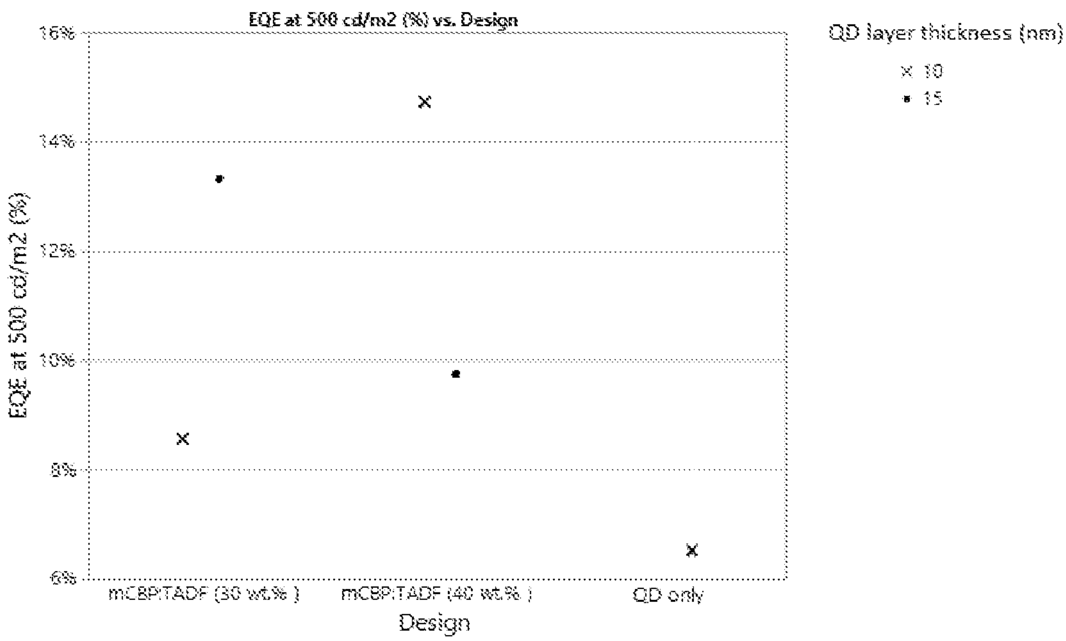
EQE at 500 cd/m2 (%) vs. Design
QD layer thickness (nm)
× 10
• 15
16%
14%
12%
10%
8%
6%
EQE at 500 cd/m2 (%)
mCBP:TADF (30 wt.% )
mCBP:TADF (40 wt.% )
QD only
Design

**FIG. 18**

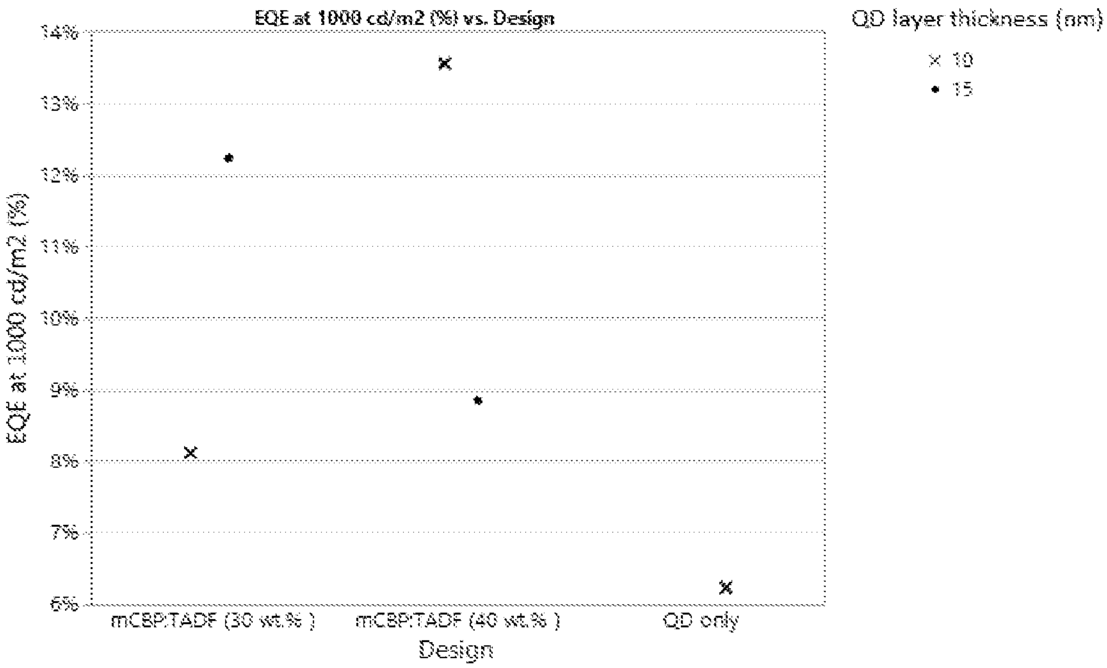
EQE at 1000 cd/m2 (%) vs. Design
QD layer thickness (nm)
× 10
• 15
EQE at 1000 cd/m2 (%)
14%
13%
12%
11%
10%
9%
8%
7%
6%
mCBP:TADF (30 wt.% )
mCBP:TADF (40 wt.% )
QD only
Design

FIG. 19

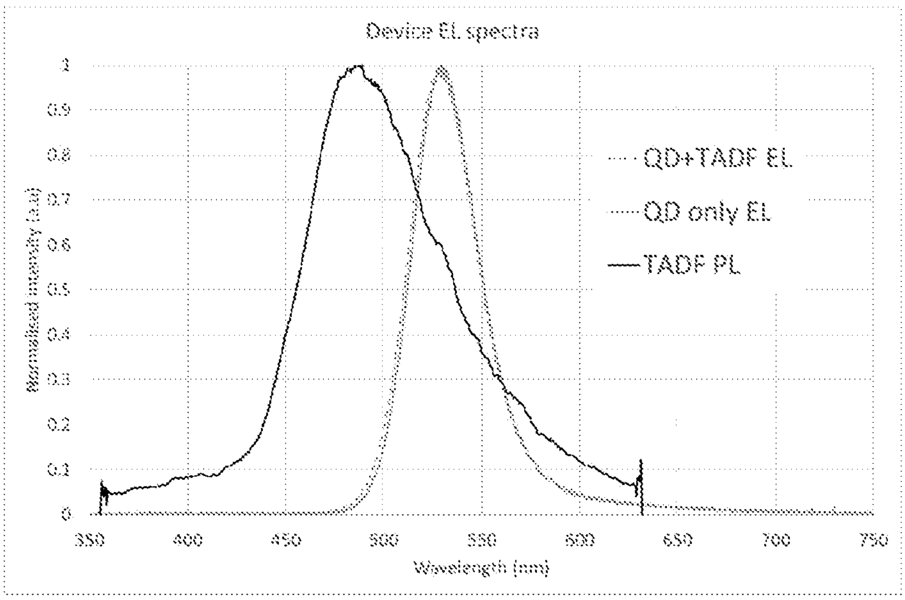
Device EL spectra
QD+TADF EL
QD only EL
TADF PL
Normalised intensity (a.u)
1
0.9
0.8
0.7
0.6
0.5
0.4
0.3
0.2
0.1
0
350
400
450
500
550
600
650
700
750
Wavelength (nm)

FIG. 20

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- CN 106997926
- CN 106997890
- WO 2015135625 A
- CN 106997889
- US 2018053907 A


### Non-patent literature cited in the description


- **FÖRSTER, TH.** *Ann. Phys.,* 1948, vol. 437, 55
- **Y.Q. ZHANG ; X.A. CAO.** *Appl. Phys. Lett.,* 2010, vol. 97, 253115
- **M.D. LEISTIKOW ; J. JOHANSEN ; A.J. KETTELARIJ ; P. LODAHL ; W.L. VOS.** *Phys. Rev. B,* 2009, vol. 79, 045301
- **K.E. GONG ; Y. ZENG ; D.F. KELLEY.** *J. Phys. Chem. C,* 2013, vol. 117, 20268
- **H. HTOON ; J.A. HOLLINGWORTH ; A.V. MALKO ; R. DICKERSON ; V.I. KLIMOV.** *Appl. Phys. Lett.,* 2003, vol. 82, 4776
- **K. GONG ; Y. ZANG ; D.F. KELLEY.** *J. Phys. Chem. C,* 2013, vol. 117, 20268